(19) Europäisches Patentamt
European Patent Office
Office européen des brevets

(11) **EP 4 742 565 A1**

(12) **EUROPEAN PATENT APPLICATION**
published in accordance with Art. 153(4) EPC

(43) Date of publication:
**13.05.2026 Bulletin 2026/20**

(21) Application number: **23946939.8**

(22) Date of filing: **28.07.2023**

(51) International Patent Classification (IPC):
***H04L 1/00*** (2006.01)

(52) Cooperative Patent Classification (CPC):
**H04L 1/00**

(86) International application number:
**PCT/CN2023/109911**

(87) International publication number:
**WO 2025/024981 (06.02.2025 Gazette 2025/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Huawei Technologies Co., Ltd.**
**Shenzhen, Guangdong 518129 (CN)**

(72) Inventors:
• **QIN, Kangjian**
**Shenzhen, Guangdong 518129 (CN)**
• **ZHANG, Huazi**
**Shenzhen, Guangdong 518129 (CN)**

• **WANG, Xianbin**
**Shenzhen, Guangdong 518129 (CN)**
• **TONG, Jiajie**
**Shenzhen, Guangdong 518129 (CN)**
• **LIU, Ke**
**Shenzhen, Guangdong 518129 (CN)**
• **WANG, Jun**
**Shenzhen, Guangdong 518129 (CN)**
• **DU, Yinggang**
**Shenzhen, Guangdong 518129 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **RATE MATCHING METHOD AND COMMUNICATION APPARATUS**

(57) Embodiments of this application provide a rate matching method and a communication apparatus. In the method, a to-be-encoded sequence is encoded based on a basis sequence corresponding to small packet encoding, to obtain a first codeword sequence whose length is 32 bits; then the first codeword sequence is interleaved to obtain a second codeword sequence; and finally, the second codeword sequence is punctured from back to front based on a value E, to obtain a third codeword sequence, where the value E indicates a quantity of bits of the second codeword sequence after rate matching, and E is a positive integer less than 32. According to the method, a code distance characteristic of a punctured first codeword sequence can be improved, so that a Hamming distance between different valid codewords is as large as possible, thereby improving decoding performance.

200

Encode a to-be-encoded sequence based on a first encoding sequence, to obtain a first codeword sequence whose length is 32 bits, where the first encoding sequence is a basis sequence corresponding to small packet encoding — S210

Interleave the first codeword sequence to obtain a second codeword sequence — S220

Puncture the second codeword sequence based on a value E, to obtain a third codeword sequence — S230

Output the third codeword sequence — S240

FIG. 2

**Description**

**TECHNICAL FIELD**

Embodiments of this application relate to the channel coding field, and more specifically, to a rate matching method and a communication apparatus.

**BACKGROUND**

Long term evolution (long term evolution, LTE)-Reed-Muller (Reed Muller, RM) code is a method for encoding a small packet (or referred to as a very short message or a small block) of 3 bits to 11 bits in an existing new radio (new radio, NR) standard. A specific encoding process is as follows. It is assumed that a small packet sequence/a very short message sequence before encoding is $c_0, c_1, ..., c_{K-1}$ ($3 \leq K \leq 11$), and a codeword sequence after LTE-RM code encoding is $d_0, d_1, ..., d_{N-1}$, where N=32. When a length E of an actually transmitted codeword sequence is less than a length N of the encoded codeword sequence $d_0, d_1, ..., d_{N-1}$, a corresponding rate matching manner is: puncturing the codeword sequence $d_0, d_1, ..., d_{N-1}$ from back to front, to be specific, starting from the last bit position of the codeword sequence $d_0, d_1, ..., d_{N-1}$ toward the front, puncturing bits in consecutive (32-E) bit positions. However, when a value of E is small, that is, a quantity of to-be-punctured bits is large, a performance bad point occurs on an output sequence after rate matching, and decoding performance is poor.

**SUMMARY**

Embodiments of this application provide a rate matching method, to improve a code distance characteristic of a punctured first codeword sequence, thereby improving decoding performance.

According to a first aspect, a rate matching method is provided. The method includes: encoding a to-be-encoded sequence based on a first encoding sequence, to obtain a first codeword sequence whose length is 32 bits, where the first encoding sequence is a basis sequence corresponding to small packet encoding; interleaving the first codeword sequence to obtain a second codeword sequence; puncturing the second codeword sequence based on a value E, to obtain a third codeword sequence, where the value E indicates a quantity of bits of the second codeword sequence after rate matching, and E is a positive integer less than 32; and outputting a third codeword sequence.

In the foregoing technical solution, before rate matching is performed on the first codeword sequence, the first codeword sequence is first interleaved based on the first encoding sequence, so that a code distance characteristic of a punctured first codeword sequence can be improved, and a Hamming distance between different valid codewords is as large as possible. In this way, a probability that a decoder incorrectly decodes a valid codeword into another valid codeword is reduced. That is, decoding performance is improved, and a probability of occurrence of a performance bad point is reduced. A code distance refers to a Hamming distance between two codewords. For example, a codeword whose length is 4 and that is obtained by encoding a message 1 (that is, a to-be-encoded sequence #1) is C1=[0 0 0 0], and another codeword whose length is 4 and that is obtained by encoding a message 2 (that is, a to-be-encoded sequence #2) is C2=[0 0 1 1]. In this case, a code distance between the two codewords is a quantity of different elements in corresponding positions in C1 and C2, and the code distance between C1 and C2 is 2. It is assumed that interleaving is not performed before puncturing, and puncturing is directly performed from back to front. If puncturing is performed in two positions, corresponding codewords obtained by puncturing C1 and C2 are C1'=[0 0] and C2'=[0 0], the code distance between the two codewords after puncturing is 0, and the two codewords are completely the same. Therefore, a decoder cannot distinguish whether the message 1 or the message 2 is sent by a transmitter. However, if C1 and C2 are interleaved, and 1st two elements are interleaved to 3rd and 4th positions, C1 becomes [0 0 0 0], and C2 becomes [1 1 0 0]. Then, puncturing is performed in two positions from back to front, so that C1"=[0 0], C2"=[1 1], and the code distance after puncturing is 2. In this way, the decoder can easily distinguish whether the message 1 or the message 2 is sent by the transmitter, thereby improving decoding performance after puncturing.

In some implementations of the first aspect, interleaving the first codeword sequence includes: interleaving the first codeword sequence based on a first interleaving pattern, where the first interleaving pattern is used for resetting positions of all or a part of the 32 bits of the first codeword sequence.

In some implementations of the first aspect, the first encoding sequence is a matrix with 32 rows and 11 columns, and the first encoding sequence is shown in the following table:

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 0 | 0 | 0 | 0 | 0 | 0 | 0 | 0 | 1 |
| 1 | 1 | 1 | 1 | 0 | 0 | 0 | 0 | 0 | 0 | 1 | 1 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 2 | 1 | 0 | 0 | 1 | 0 | 0 | 1 | 0 | 1 | 1 | 1 |
| 3 | 1 | 0 | 1 | 1 | 0 | 0 | 0 | 0 | 1 | 0 | 1 |
| 4 | 1 | 1 | 1 | 1 | 0 | 0 | 0 | 1 | 0 | 0 | 1 |
| 5 | 1 | 1 | 0 | 0 | 1 | 0 | 1 | 1 | 1 | 0 | 1 |
| 6 | 1 | 0 | 1 | 0 | 1 | 0 | 1 | 0 | 1 | 1 | 1 |
| 7 | 1 | 0 | 0 | 1 | 1 | 0 | 0 | 1 | 1 | 0 | 1 |
| 8 | 1 | 1 | 0 | 1 | 1 | 0 | 0 | 1 | 0 | 1 | 1 |
| 9 | 1 | 0 | 1 | 1 | 1 | 0 | 1 | 0 | 0 | 1 | 1 |
| 10 | 1 | 0 | 1 | 0 | 0 | 1 | 1 | 1 | 0 | 1 | 1 |
| 11 | 1 | 1 | 1 | 0 | 0 | 1 | 1 | 0 | 1 | 0 | 1 |
| 12 | 1 | 0 | 0 | 1 | 0 | 1 | 0 | 1 | 1 | 1 | 1 |
| 13 | 1 | 1 | 0 | 1 | 0 | 1 | 0 | 1 | 0 | 1 | 1 |
| 14 | 1 | 0 | 0 | 0 | 1 | 1 | 0 | 1 | 0 | 0 | 1 |
| 15 | 1 | 1 | 0 | 0 | 1 | 1 | 1 | 1 | 0 | 1 | 1 |
| 16 | 1 | 1 | 1 | 0 | 1 | 1 | 1 | 0 | 0 | 1 | 0 |
| 17 | 1 | 0 | 0 | 1 | 1 | 1 | 0 | 0 | 1 | 0 | 0 |
| 18 | 1 | 1 | 0 | 1 | 1 | 1 | 1 | 1 | 0 | 0 | 0 |
| 19 | 1 | 0 | 0 | 0 | 0 | 1 | 1 | 0 | 0 | 0 | 0 |
| 20 | 1 | 0 | 1 | 0 | 0 | 0 | 1 | 0 | 0 | 0 | 1 |
| 21 | 1 | 1 | 0 | 1 | 0 | 0 | 0 | 0 | 0 | 1 | 1 |
| 22 | 1 | 0 | 0 | 0 | 1 | 0 | 0 | 1 | 1 | 0 | 1 |
| 23 | 1 | 1 | 1 | 0 | 1 | 0 | 0 | 0 | 1 | 1 | 1 |
| 24 | 1 | 1 | 1 | 1 | 1 | 0 | 1 | 1 | 1 | 1 | 0 |
| 25 | 1 | 1 | 0 | 0 | 0 | 1 | 1 | 1 | 0 | 0 | 1 |
| 26 | 1 | 0 | 1 | 1 | 0 | 1 | 0 | 0 | 1 | 1 | 0 |
| 27 | 1 | 1 | 1 | 1 | 0 | 1 | 0 | 1 | 1 | 1 | 0 |
| 28 | 1 | 0 | 1 | 0 | 1 | 1 | 1 | 0 | 1 | 0 | 0 |
| 29 | 1 | 0 | 1 | 1 | 1 | 1 | 1 | 1 | 1 | 0 | 0 |
| 30 | 1 | 1 | 1 | 1 | 1 | 1 | 1 | 1 | 1 | 1 | 1 |
| 31 | 1 | 0 | 0 | 0 | 0 | 0 | 0 | 0 | 0 | 0 | 0 |

In some implementations of the first aspect, a length of the to-be-encoded sequence is K, and when K is any value in 3 to 11, the first interleaving pattern is shown in Table #1 or Table #2 below:

Table #1

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 17 | 8 | 28 | 12 | 5 | 16 | 26 | 20 | 24 | 24 | 31 | 28 | 6 |
| 1 | 13 | 5 | 15 | 9 | 18 | 13 | 23 | 17 | 2 | 21 | 16 | 25 | 9 | 29 | 14 |
| 2 | 22 | 6 | 4 | 10 | 19 | 14 | 10 | 18 | 29 | 22 | 7 | 26 | 11 | 30 | 27 |
| 3 | 3 | 7 | 1 | 11 | 12 | 15 | 25 | 19 | 21 | 23 | 20 | 27 | 0 | 31 | 8 |

Table #2

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 16 | 4 | 4 | 8 | 15 | 12 | 10 | 16 | 12 | 20 | 20 | 24 | 24 | 28 | 28 |
| 1 | 14 | 5 | 7 | 9 | 1 | 13 | 17 | 17 | 11 | 21 | 21 | 25 | 25 | 29 | 29 |
| 2 | 3 | 6 | 9 | 10 | 8 | 14 | 5 | 18 | 2 | 22 | 22 | 26 | 26 | 30 | 30 |
| 3 | 0 | 7 | 6 | 11 | 13 | 15 | 19 | 19 | 18 | 23 | 23 | 27 | 27 | 31 | 31 |

i represents an $(i+1)^{th}$ position of the second codeword sequence, P(i) represents a bit that is in a $(P(i)+1)^{th}$ position of the first codeword sequence and that is placed in the $(i+1)^{th}$ position of the second codeword sequence, and $0 \leq i \leq 31$.

It may be understood that the second codeword sequence is determined based on the first interleaving pattern. When the second codeword sequence needs to be punctured, puncturing needs to be performed from back to front. Therefore, an interleaving pattern in this application may also be understood as a puncturing sequence. In this application, the puncturing sequence and the interleaving pattern are interchangeable.

The first interleaving patterns corresponding to Table #1 and Table #2 may be K nested puncturing sequences. The K nested puncturing sequence means that rate matching is performed on a plurality of to-be-encoded sequences of different lengths by using a same puncturing sequence. The plurality of to-be-encoded sequences of different lengths are sequences whose lengths are 3 to 11.

In the foregoing technical solution, the first codeword sequence is interleaved based on Table #1 and Table #2, to obtain the second codeword sequence, and then puncturing is performed from back to front for (32-E) times on the second codeword sequence, so that it can be ensured that an output sequence (that is, the third codeword sequence) after rate matching has no performance bad point. In addition, when the first codeword sequence is punctured, a performance bad point occurs only when a quantity of punctured bits exceeds 12. Therefore, interleaving may be performed only in $1^{st}$ 20 positions of the first codeword sequence. In this way, this application proposes an interleaving pattern that is based on Table #3. Based on the interleaving pattern, bits in the last 12 bit positions in the second codeword sequence may be the same as bits in the last 12 bit positions in the first codeword sequence. In comparison with interleaving performed on bits in all positions, interleaving performed on bits in remaining positions can reduce implementation complexity based on the interleaving pattern.

In the foregoing technical solution, the interleaving pattern provided in Table 2 or Table 3 can improve the decoding performance and avoid the performance bad point.

In some implementations of the first aspect, a length of the to-be-encoded sequence is K, and when K is equal to 3, the first interleaving pattern is shown in Table #3:

Table #3

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 28 | 4 | 22 | 8 | 2 | 12 | 1 | 16 | 4 | 20 | 27 | 24 | 18 | 28 | 10 |
| 1 | 14 | 5 | 16 | 9 | 29 | 13 | 31 | 17 | 13 | 21 | 17 | 25 | 9 | 29 | 11 |
| 2 | 25 | 6 | 8 | 10 | 30 | 14 | 15 | 18 | 3 | 22 | 6 | 26 | 24 | 30 | 5 |
| 3 | 23 | 7 | 26 | 11 | 21 | 15 | 20 | 19 | 12 | 23 | 19 | 27 | 0 | 31 | 7 |

or when K is equal to 4, the first interleaving pattern is shown in Table #4:

Table #4

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 20 | 8 | 6 | 12 | 12 | 16 | 13 | 20 | 9 | 24 | 28 | 28 | 7 |
| 1 | 29 | 5 | 14 | 9 | 3 | 13 | 25 | 17 | 0 | 21 | 4 | 25 | 27 | 29 | 5 |
| 2 | 21 | 6 | 15 | 10 | 24 | 14 | 23 | 18 | 11 | 22 | 31 | 26 | 26 | 30 | 18 |
| 3 | 1 | 7 | 17 | 11 | 19 | 15 | 8 | 19 | 22 | 23 | 2 | 27 | 16 | 31 | 10 |

or when K is equal to 5, the first interleaving pattern is shown in Table #5:

Table #5

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 4 | 8 | 3 | 12 | 16 | 16 | 25 | 20 | 24 | 24 | 21 | 28 | 15 |
| 1 | 17 | 5 | 0 | 9 | 13 | 13 | 10 | 17 | 6 | 21 | 27 | 25 | 19 | 29 | 7 |
| 2 | 14 | 6 | 5 | 10 | 11 | 14 | 29 | 18 | 23 | 22 | 9 | 26 | 26 | 30 | 12 |
| 3 | 8 | 7 | 28 | 11 | 2 | 15 | 31 | 19 | 1 | 23 | 18 | 27 | 22 | 31 | 20 |

or when K is equal to 6, the first interleaving pattern is shown in Table #6:

Table #6

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 29 | 4 | 7 | 8 | 25 | 12 | 5 | 16 | 3 | 20 | 20 | 24 | 22 | 28 | 10 |
| 1 | 16 | 5 | 21 | 9 | 4 | 13 | 6 | 17 | 15 | 21 | 8 | 25 | 13 | 29 | 19 |
| 2 | 26 | 6 | 1 | 10 | 28 | 14 | 9 | 18 | 14 | 22 | 2 | 26 | 31 | 30 | 27 |
| 3 | 24 | 7 | 0 | 11 | 30 | 15 | 17 | 19 | 12 | 23 | 23 | 27 | 18 | 31 | 11 |

or when K is equal to 7, the first interleaving pattern is shown in Table #7:

Table #7

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 17 | 4 | 22 | 8 | 1 | 12 | 7 | 16 | 19 | 20 | 29 | 24 | 20 | 28 | 28 |
| 1 | 26 | 5 | 3 | 9 | 8 | 13 | 12 | 17 | 31 | 21 | 6 | 25 | 16 | 29 | 11 |
| 2 | 24 | 6 | 21 | 10 | 10 | 14 | 23 | 18 | 14 | 22 | 25 | 26 | 13 | 30 | 5 |
| 3 | 9 | 7 | 0 | 11 | 18 | 15 | 2 | 19 | 15 | 23 | 27 | 27 | 30 | 31 | 4 |

or when K is equal to 8, the first interleaving pattern is shown in Table #8:

Table #8

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 15 | 8 | 31 | 12 | 27 | 16 | 1 | 20 | 29 | 24 | 12 | 28 | 9 |
| 1 | 17 | 5 | 10 | 9 | 18 | 13 | 7 | 17 | 20 | 21 | 4 | 25 | 13 | 29 | 5 |
| 2 | 16 | 6 | 8 | 10 | 6 | 14 | 26 | 18 | 3 | 22 | 0 | 26 | 14 | 30 | 19 |
| 3 | 28 | 7 | 2 | 11 | 11 | 15 | 22 | 19 | 23 | 23 | 21 | 27 | 25 | 31 | 24 |

or when K is equal to 9, the first interleaving pattern is shown in Table #9:

Table #9

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 7 | 8 | 1 | 12 | 3 | 16 | 27 | 20 | 20 | 24 | 18 | 28 | 9 |
| 1 | 16 | 5 | 23 | 9 | 0 | 13 | 8 | 17 | 28 | 21 | 4 | 25 | 22 | 29 | 24 |
| 2 | 12 | 6 | 6 | 10 | 31 | 14 | 29 | 18 | 15 | 22 | 19 | 26 | 14 | 30 | 13 |
| 3 | 10 | 7 | 21 | 11 | 26 | 15 | 17 | 19 | 5 | 23 | 11 | 27 | 2 | 31 | 25 |

or when K is equal to 10, the first interleaving pattern is shown in Table #10:

Table #10

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 16 | 4 | 25 | 8 | 3 | 12 | 23 | 16 | 7 | 20 | 21 | 24 | 29 | 28 | 28 |
| 1 | 15 | 5 | 24 | 9 | 1 | 13 | 0 | 17 | 19 | 21 | 6 | 25 | 14 | 29 | 9 |
| 2 | 11 | 6 | 8 | 10 | 20 | 14 | 13 | 18 | 2 | 22 | 30 | 26 | 27 | 30 | 18 |
| 3 | 10 | 7 | 4 | 11 | 26 | 15 | 5 | 19 | 12 | 23 | 31 | 27 | 22 | 31 | 17 |

or when K is equal to 11, the first interleaving pattern is shown in Table #11:

Table #11

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 27 | 8 | 4 | 12 | 7 | 16 | 10 | 20 | 24 | 24 | 23 | 28 | 5 |
| 1 | 29 | 5 | 19 | 9 | 21 | 13 | 12 | 17 | 16 | 21 | 31 | 25 | 9 | 29 | 17 |
| 2 | 18 | 6 | 6 | 10 | 20 | 14 | 25 | 18 | 14 | 22 | 8 | 26 | 3 | 30 | 11 |
| 3 | 15 | 7 | 22 | 11 | 0 | 15 | 13 | 19 | 28 | 23 | 1 | 27 | 2 | 31 | 26 |

i represents an $(i+1)^{th}$ position of the second codeword sequence, P(i) represents a bit that is in a $(P(i)+1)^{th}$ position of the first codeword sequence and that is placed in the $(i+1)^{th}$ position of the second codeword sequence, and $0 \leq i \leq 31$.

It should be understood that puncturing sequences provided in Table #3 to Table #11 are K non-nested puncturing sequences. The K non-nested puncturing sequence means that rate matching is performed on a plurality of to-be-encoded sequences of different lengths by using respective puncturing sequences.

In the foregoing technical solution, the first codeword sequence is interleaved based on the corresponding interleaving patterns in Table #4 to Table #11 for the to-be-encoded sequence whose length is K, to obtain the second codeword sequence, and then the second codeword sequence is punctured from back to front for (32-E) times, so that it can be ensured that the output sequence (that is, the third codeword sequence) after rate matching has no performance bad point.

In some implementations of the first aspect, the first encoding sequence is a matrix with 32 rows and 11 columns, and the first encoding sequence is shown in the following table:

| i | $M_{i,0}$ | $M_{i,1}$ | $M_{i,2}$ | $M_{i,3}$ | $M_{i,4}$ | $M_{i,6}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 0 | 0 | 0 | 0 | 0 | 0 | 0 | 0 | 0 | 0 |
| 1 | 1 | 1 | 0 | 0 | 0 | 0 | 0 | 0 | 0 | 0 | 1 |
| 2 | 1 | 0 | 1 | 0 | 0 | 0 | 1 | 0 | 0 | 0 | 1 |
| 3 | 1 | 1 | 1 | 0 | 0 | 0 | 0 | 0 | 0 | 1 | 1 |
| 4 | 1 | 0 | 0 | 1 | 0 | 0 | 1 | 0 | 1 | 1 | 1 |
| 5 | 1 | 1 | 0 | 1 | 0 | 0 | 0 | 0 | 0 | 1 | 1 |
| 6 | 1 | 0 | 1 | 1 | 0 | 0 | 0 | 0 | 1 | 0 | 1 |
| 7 | 1 | 1 | 1 | 1 | 0 | 0 | 0 | 1 | 0 | 0 | 1 |
| 8 | 1 | 0 | 0 | 0 | 1 | 0 | 0 | 1 | 1 | 0 | 1 |
| 9 | 1 | 1 | 0 | 0 | 1 | 0 | 1 | 1 | 1 | 0 | 1 |
| 10 | 1 | 0 | 1 | 0 | 1 | 0 | 1 | 0 | 1 | 1 | 1 |
| 11 | 1 | 1 | 1 | 0 | 1 | 0 | 0 | 0 | 1 | 1 | 1 |
| 12 | 1 | 0 | 0 | 1 | 1 | 0 | 0 | 1 | 1 | 0 | 1 |
| 13 | 1 | 1 | 0 | 1 | 1 | 0 | 0 | 1 | 0 | 1 | 1 |
| 14 | 1 | 0 | 1 | 1 | 1 | 0 | 1 | 0 | 0 | 1 | 1 |

(continued)

| i | $M_{i,0}$ | $M_{i,1}$ | $M_{i,2}$ | $M_{i,3}$ | $M_{i,4}$ | $M_{i,6}$ | $M_{i,6}$ | $M_{i,7}$ | $M_{i,8}$ | $M_{i,9}$ | $M_{i,10}$ |
|---|---|---|---|---|---|---|---|---|---|---|---|
| 15 | 1 | 1 | 1 | 1 | 1 | 0 | 1 | 1 | 1 | 1 | 0 |
| 16 | 1 | 0 | 0 | 0 | 0 | 1 | 1 | 0 | 0 | 0 | 0 |
| 17 | 1 | 1 | 0 | 0 | 0 | 1 | 1 | 1 | 0 | 0 | 1 |
| 18 | 1 | 0 | 1 | 0 | 0 | 1 | 1 | 1 | 0 | 1 | 1 |
| 19 | 1 | 1 | 1 | 0 | 0 | 1 | 1 | 0 | 1 | 0 | 1 |
| 20 | 1 | 0 | 0 | 1 | 0 | 1 | 0 | 1 | 1 | 1 | 1 |
| 21 | 1 | 1 | 0 | 1 | 0 | 1 | 0 | 1 | 0 | 1 | 1 |
| 22 | 1 | 0 | 1 | 1 | 0 | 1 | 0 | 0 | 1 | 1 | 0 |
| 23 | 1 | 1 | 1 | 1 | 0 | 1 | 0 | 1 | 1 | 1 | 0 |
| 24 | 1 | 0 | 0 | 0 | 1 | 1 | 0 | 1 | 0 | 0 | 1 |
| 25 | 1 | 1 | 0 | 0 | 1 | 1 | 1 | 1 | 0 | 1 | 1 |
| 26 | 1 | 0 | 1 | 0 | 1 | 1 | 1 | 0 | 1 | 0 | 0 |
| 27 | 1 | 1 | 1 | 0 | 1 | 1 | 1 | 0 | 0 | 1 | 0 |
| 28 | 1 | 0 | 0 | 1 | 1 | 1 | 0 | 0 | 1 | 0 | 0 |
| 29 | 1 | 1 | 0 | 1 | 1 | 1 | 1 | 1 | 0 | 0 | 0 |
| 30 | 1 | 0 | 1 | 1 | 1 | 1 | 1 | 1 | 1 | 0 | 0 |
| 31 | 1 | 1 | 1 | 1 | 1 | 1 | 1 | 1 | 1 | 1 | 1 |

In some implementations of the first aspect, a length of the to-be-encoded sequence is K, and when K is any value in 3 to 11, the first interleaving pattern is shown in the following table:

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 31 | 4 | 28 | 8 | 26 | 12 | 9 | 16 | 22 | 20 | 15 | 24 | 0 | 28 | 10 |
| 1 | 21 | 5 | 25 | 9 | 29 | 13 | 11 | 17 | 4 | 21 | 27 | 25 | 14 | 29 | 24 |
| 2 | 8 | 6 | 7 | 10 | 18 | 14 | 18 | 18 | 30 | 22 | 12 | 26 | 19 | 30 | 23 |
| 3 | 6 | 7 | 3 | 11 | 20 | 15 | 17 | 19 | 5 | 23 | 2 | 27 | 1 | 31 | 13 |

i represents an $(i+1)^{th}$ position of the second codeword sequence, P(i) represents a bit that is in a $(P(i)+1)^{th}$ position of the first codeword sequence and that is placed in the $(i+1)^{th}$ position of the second codeword sequence, and $0 \leq i \leq 31$.

It should be understood that the puncturing sequence is a K nested puncturing sequence.

Based on the foregoing technical solution, it can be ensured that the output sequence (that is, the third codeword sequence) after rate matching has no performance bad point.

In some implementations of the first aspect, a length of the to-be-encoded sequence is K, and when K is equal to 3, the first interleaving pattern is shown in Table #12:

Table #12

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 26 | 4 | 8 | 8 | 4 | 12 | 3 | 16 | 7 | 20 | 23 | 24 | 29 | 28 | 18 |
| 1 | 24 | 5 | 27 | 9 | 30 | 13 | 0 | 17 | 21 | 21 | 28 | 25 | 14 | 29 | 19 |
| 2 | 11 | 6 | 13 | 10 | 31 | 14 | 25 | 18 | 6 | 22 | 10 | 26 | 15 | 30 | 9 |
| 3 | 17 | 7 | 22 | 11 | 5 | 15 | 2 | 19 | 20 | 23 | 16 | 27 | 1 | 31 | 12 |

or when K is equal to 4, the first interleaving pattern is shown in Table #13:

Table #13

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 3 | 8 | 10 | 12 | 20 | 16 | 21 | 20 | 14 | 24 | 26 | 28 | 12 |
| 1 | 2 | 5 | 24 | 9 | 6 | 13 | 17 | 17 | 1 | 21 | 7 | 25 | 23 | 29 | 9 |
| 2 | 5 | 6 | 25 | 10 | 15 | 14 | 11 | 18 | 19 | 22 | 0 | 26 | 22 | 30 | 29 |
| 3 | 31 | 7 | 28 | 11 | 16 | 15 | 13 | 19 | 8 | 23 | 4 | 27 | 27 | 31 | 18 |

or when K is equal to 5, the first interleaving pattern is shown in Table #14:

Table #14

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 28 | 4 | 31 | 8 | 6 | 12 | 27 | 16 | 17 | 20 | 15 | 24 | 5 | 28 | 25 |
| 1 | 1 | 5 | 7 | 9 | 21 | 13 | 18 | 17 | 10 | 21 | 23 | 25 | 16 | 29 | 12 |
| 2 | 13 | 6 | 9 | 10 | 19 | 14 | 30 | 18 | 11 | 22 | 14 | 26 | 22 | 30 | 20 |
| 3 | 24 | 7 | 26 | 11 | 4 | 15 | 0 | 19 | 3 | 23 | 29 | 27 | 8 | 31 | 2 |

or when K is equal to 6, the first interleaving pattern is shown in Table #15:

Table #15

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 27 | 4 | 22 | 8 | 17 | 12 | 9 | 16 | 6 | 20 | 2 | 24 | 8 | 28 | 18 |
| 1 | 12 | 5 | 3 | 9 | 7 | 13 | 10 | 17 | 25 | 21 | 13 | 25 | 21 | 29 | 16 |
| 2 | 15 | 6 | 5 | 10 | 26 | 14 | 14 | 18 | 24 | 22 | 4 | 26 | 0 | 30 | 23 |
| 3 | 30 | 7 | 1 | 11 | 31 | 15 | 28 | 19 | 20 | 23 | 11 | 27 | 29 | 31 | 19 |

or when K is equal to 7, the first interleaving pattern is shown in Table #16:

Table #16

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 8 | 4 | 28 | 8 | 3 | 12 | 12 | 16 | 16 | 20 | 30 | 24 | 2 | 28 | 26 |
| 1 | 5 | 5 | 1 | 9 | 13 | 13 | 20 | 17 | 0 | 21 | 10 | 25 | 27 | 29 | 19 |
| 2 | 14 | 6 | 15 | 10 | 18 | 14 | 11 | 18 | 24 | 22 | 17 | 26 | 21 | 30 | 9 |
| 3 | 22 | 7 | 6 | 11 | 29 | 15 | 4 | 19 | 25 | 23 | 23 | 27 | 31 | 31 | 7 |

or when K is equal to 8, the first interleaving pattern is shown in Table #17:

Table #17

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 26 | 4 | 18 | 8 | 13 | 12 | 23 | 16 | 3 | 20 | 30 | 24 | 20 | 28 | 14 |
| 1 | 31 | 5 | 0 | 9 | 29 | 13 | 12 | 17 | 2 | 21 | 7 | 25 | 21 | 29 | 9 |
| 2 | 25 | 6 | 4 | 10 | 10 | 14 | 22 | 18 | 6 | 22 | 1 | 26 | 24 | 30 | 16 |
| 3 | 28 | 7 | 27 | 11 | 19 | 15 | 8 | 19 | 11 | 23 | 5 | 27 | 17 | 31 | 15 |

or when K is equal to 9, the first interleaving pattern is shown in Table #18:

Table #18

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 1 | 4 | 27 | 8 | 31 | 12 | 6 | 16 | 23 | 20 | 2 | 24 | 29 | 28 | 14 |
| 1 | 3 | 5 | 18 | 9 | 20 | 13 | 13 | 17 | 26 | 21 | 7 | 25 | 8 | 29 | 15 |
| 2 | 5 | 6 | 10 | 10 | 0 | 14 | 30 | 18 | 25 | 22 | 16 | 26 | 24 | 30 | 21 |
| 3 | 12 | 7 | 11 | 11 | 22 | 15 | 28 | 19 | 9 | 23 | 19 | 27 | 4 | 31 | 17 |

or when K is equal to 10, the first interleaving pattern is shown in Table #19:

Table #19

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 27 | 4 | 18 | 8 | 13 | 12 | 11 | 16 | 12 | 20 | 5 | 24 | 30 | 28 | 26 |
| 1 | 6 | 5 | 2 | 9 | 7 | 13 | 1 | 17 | 16 | 21 | 10 | 25 | 24 | 29 | 14 |
| 2 | 19 | 6 | 8 | 10 | 3 | 25 | 21 | 18 | 4 | 22 | 31 | 26 | 23 | 30 | 29 |
| 3 | 17 | 7 | 15 | 11 | 22 | 15 | 9 | 19 | 20 | 23 | 0 | 27 | 9 | 31 | 28 |

or when K is equal to 11, the first interleaving pattern is shown in Table #20:

Table #20

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 5 | 4 | 29 | 8 | 16 | 12 | 12 | 16 | 18 | 20 | 15 | 24 | 11 | 28 | 9 |
| 1 | 25 | 5 | 2 | 9 | 7 | 13 | 20 | 17 | 27 | 21 | 0 | 25 | 14 | 29 | 28 |
| 2 | 10 | 6 | 31 | 10 | 8 | 14 | 17 | 18 | 24 | 22 | 13 | 26 | 6 | 30 | 19 |

i represents an (i+1)th position of the second codeword sequence, P(i) represents a bit that is in a (P(i)+1)th position of the first codeword sequence and that is placed in the (i+1)th position of the second codeword sequence, and $0 \leq i \leq 31$.

It should be understood that puncturing sequences corresponding to Table #12 to Table #20 are K non-nested puncturing sequences.

Based on the foregoing technical solution, it can be ensured that the output sequence (that is, the third codeword sequence) after rate matching has no performance bad point.

According to a second aspect, a rate matching method is provided. The method includes: performing row interleaving on a first encoding sequence, to obtain a second encoding sequence, where the first encoding sequence is a basis sequence corresponding to small packet encoding; encoding a to-be-encoded sequence based on the second encoding sequence, to obtain a second codeword sequence whose length is 32 bits; puncturing the second codeword sequence based on a value E, to obtain a third codeword sequence, where the value E indicates a quantity of bits of the second codeword sequence after rate matching, and E is a positive integer less than 32; and outputting the third codeword sequence.

In the foregoing solution, the to-be-encoded sequence is first encoded based on the first encoding sequence, to obtain a first codeword sequence, and then the first codeword sequence is interleaved based on a first interleaving pattern, to obtain the second codeword sequence. However, in the solution shown in the first aspect, row interleaving is first performed on the first encoding sequence based on the first interleaving pattern, to obtain the second encoding sequence, and then the to-be-encoded sequence is encoded based on the second encoding sequence, to obtain the second codeword sequence. It may be understood that, in the method shown in the first aspect and the method shown in the second aspect, when the first encoding sequences are the same, the to-be-encoded sequences are the same, and the first interleaving patterns are the same, the second codeword sequences obtained in the two methods are the same.

Therefore, for beneficial effects of the second aspect, refer to the descriptions in the first aspect. Details are not described herein again.

In some implementations of the second aspect, performing row interleaving on the first encoding sequence includes: performing row interleaving on the first encoding sequence based on the first interleaving pattern, where the first interleaving pattern is used for resetting positions of all or a part of 32 rows in the first encoding sequence.

In some implementations of the second aspect, the first encoding sequence is a matrix with 32 rows and 11 columns, and the first encoding sequence is shown in the following table:

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 0 | 0 | 0 | 0 | 0 | 0 | 0 | 0 | 1 |
| 1 | 1 | 1 | 1 | 0 | 0 | 0 | 0 | 0 | 0 | 1 | 1 |
| 2 | 1 | 0 | 0 | 1 | 0 | 0 | 1 | 0 | 1 | 1 | 1 |
| 3 | 1 | 0 | 1 | 1 | 0 | 0 | 0 | 0 | 1 | 0 | 1 |
| 4 | 1 | 1 | 1 | 1 | 0 | 0 | 0 | 1 | 0 | 0 | 1 |
| 5 | 1 | 1 | 0 | 0 | 1 | 0 | 1 | 1 | 1 | 0 | 1 |
| 6 | 1 | 0 | 1 | 0 | 1 | 0 | 1 | 0 | 1 | 1 | 1 |
| 7 | 1 | 0 | 0 | 1 | 1 | 0 | 0 | 1 | 1 | 0 | 1 |
| 8 | 1 | 1 | 0 | 1 | 1 | 0 | 0 | 1 | 0 | 1 | 1 |
| 9 | 1 | 0 | 1 | 1 | 1 | 0 | 1 | 0 | 0 | 1 | 1 |
| 10 | 1 | 0 | 1 | 0 | 0 | 1 | 1 | 1 | 0 | 1 | 1 |
| 11 | 1 | 1 | 1 | 0 | 0 | 1 | 1 | 0 | 1 | 0 | 1 |
| 12 | 1 | 0 | 0 | 1 | 0 | 1 | 0 | 1 | 1 | 1 | 1 |
| 13 | 1 | 1 | 0 | 1 | 0 | 1 | 0 | 1 | 0 | 1 | 1 |
| 14 | 1 | 0 | 0 | 0 | 1 | 1 | 0 | 1 | 0 | 0 | 1 |
| 15 | 1 | 1 | 0 | 0 | 1 | 1 | 1 | 1 | 0 | 1 | 1 |
| 16 | 1 | 1 | 1 | 0 | 1 | 1 | 1 | 0 | 0 | 1 | 0 |
| 17 | 1 | 0 | 0 | 1 | 1 | 1 | 0 | 0 | 1 | 0 | 0 |
| 18 | 1 | 1 | 0 | 1 | 1 | 1 | 1 | 1 | 0 | 0 | 0 |
| 19 | 1 | 0 | 0 | 0 | 0 | 1 | 1 | 0 | 0 | 0 | 0 |
| 20 | 1 | 0 | 1 | 0 | 0 | 0 | 1 | 0 | 0 | 0 | 1 |
| 21 | 1 | 1 | 0 | 1 | 0 | 0 | 0 | 0 | 0 | 1 | 1 |
| 22 | 1 | 0 | 0 | 0 | 1 | 0 | 0 | 1 | 1 | 0 | 1 |
| 23 | 1 | 1 | 1 | 0 | 1 | 0 | 0 | 0 | 1 | 1 | 1 |
| 24 | 1 | 1 | 1 | 1 | 1 | 0 | 1 | 1 | 1 | 1 | 0 |
| 25 | 1 | 1 | 0 | 0 | 0 | 1 | 1 | 1 | 0 | 0 | 1 |
| 26 | 1 | 0 | 1 | 1 | 0 | 1 | 0 | 0 | 1 | 1 | 0 |
| 27 | 1 | 1 | 1 | 1 | 0 | 1 | 0 | 1 | 1 | 1 | 0 |
| 28 | 1 | 0 | 1 | 0 | 1 | 1 | 1 | 0 | 1 | 0 | 0 |
| 29 | 1 | 0 | 1 | 1 | 1 | 1 | 1 | 1 | 1 | 0 | 0 |
| 30 | 1 | 1 | 1 | 1 | 1 | 1 | 1 | 1 | 1 | 1 | 1 |
| 31 | 1 | 0 | 0 | 0 | 0 | 0 | 0 | 0 | 0 | 0 | 0 |

In some implementations of the second aspect, the first interleaving pattern is shown in Table #21 or Table #22 below:

Table #21

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 17 | 8 | 28 | 12 | 5 | 16 | 26 | 20 | 24 | 24 | 31 | 28 | 6 |
| 1 | 13 | 5 | 15 | 9 | 18 | 13 | 23 | 17 | 2 | 21 | 16 | 25 | 9 | 29 | 14 |
| 2 | 22 | 6 | 4 | 10 | 19 | 14 | 10 | 18 | 29 | 22 | 7 | 26 | 11 | 30 | 27 |
| 3 | 3 | 7 | 1 | 11 | 12 | 15 | 25 | 19 | 21 | 23 | 20 | 27 | 0 | 31 | 8 |

Table #22

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 16 | 4 | 4 | 8 | 15 | 12 | 10 | 16 | 12 | 20 | 20 | 24 | 24 | 28 | 28 |
| 1 | 14 | 5 | 7 | 9 | 1 | 13 | 17 | 17 | 11 | 21 | 21 | 25 | 25 | 29 | 29 |
| 2 | 3 | 6 | 9 | 10 | 8 | 14 | 5 | 18 | 2 | 22 | 22 | 26 | 26 | 30 | 30 |
| 3 | 0 | 7 | 6 | 11 | 13 | 15 | 19 | 19 | 18 | 23 | 23 | 27 | 27 | 31 | 31 |

i represents an $(i+1)^{th}$ row in the first encoding sequence, P(i) represents a row element that corresponds to a $(P(i)+1)^{th}$ row in the first encoding sequence and that is placed in an $(i+1)^{th}$ row in the second encoding sequence, and $0 \le i \le 31$.

In some implementations of the second aspect, a length of the to-be-encoded sequence is K, $3 \le K \le 11$, and when K is equal to 3, the first interleaving pattern is shown in Table #23:

Table #23

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 28 | 4 | 22 | 8 | 2 | 12 | 1 | 16 | 4 | 20 | 27 | 24 | 18 | 28 | 10 |
| 1 | 14 | 5 | 16 | 9 | 29 | 13 | 31 | 17 | 13 | 21 | 17 | 25 | 9 | 29 | 11 |
| 2 | 25 | 6 | 8 | 10 | 30 | 14 | 15 | 18 | 3 | 22 | 6 | 26 | 24 | 30 | 5 |
| 3 | 23 | 7 | 26 | 11 | 21 | 15 | 20 | 19 | 12 | 23 | 19 | 27 | 0 | 31 | 7 |

or when K is equal to 4, the first interleaving pattern is shown in Table #24:

Table #24

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 20 | 8 | 6 | 12 | 12 | 16 | 13 | 20 | 9 | 24 | 28 | 28 | 7 |
| 1 | 29 | 5 | 14 | 9 | 3 | 13 | 25 | 17 | 0 | 21 | 4 | 25 | 27 | 29 | 5 |
| 2 | 21 | 6 | 15 | 10 | 24 | 14 | 23 | 18 | 11 | 22 | 31 | 26 | 26 | 30 | 18 |
| 3 | 1 | 7 | 17 | 11 | 19 | 15 | 8 | 19 | 22 | 23 | 2 | 27 | 16 | 31 | 10 |

or when K is equal to 5, the first interleaving pattern is shown in Table #25:

Table #25

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 4 | 8 | 3 | 12 | 16 | 16 | 25 | 20 | 24 | 24 | 21 | 28 | 15 |
| 1 | 17 | 5 | 0 | 9 | 13 | 13 | 10 | 17 | 6 | 21 | 27 | 25 | 19 | 29 | 7 |
| 2 | 14 | 6 | 5 | 10 | 11 | 14 | 29 | 18 | 23 | 22 | 9 | 26 | 26 | 30 | 12 |
| 3 | 8 | 7 | 28 | 11 | 2 | 15 | 31 | 19 | 1 | 23 | 18 | 27 | 22 | 31 | 20 |

or when K is equal to 6, the first interleaving pattern is shown in Table #26:

Table #26

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 29 | 4 | 7 | 8 | 25 | 12 | 5 | 16 | 3 | 20 | 20 | 24 | 22 | 28 | 10 |
| 1 | 16 | 5 | 21 | 9 | 4 | 13 | 6 | 17 | 15 | 21 | 8 | 25 | 13 | 29 | 19 |
| 2 | 26 | 6 | 1 | 10 | 28 | 14 | 9 | 18 | 14 | 22 | 2 | 26 | 31 | 30 | 27 |
| 3 | 24 | 7 | 0 | 11 | 30 | 15 | 17 | 19 | 12 | 23 | 23 | 27 | 18 | 31 | 11 |

or when K is equal to 7, the first interleaving pattern is shown in Table #27:

Table #27

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 17 | 4 | 22 | 8 | 1 | 12 | 7 | 16 | 19 | 20 | 29 | 24 | 20 | 28 | 28 |
| 1 | 26 | 5 | 3 | 9 | 8 | 13 | 12 | 17 | 31 | 21 | 6 | 25 | 16 | 29 | 11 |
| 2 | 24 | 6 | 21 | 10 | 10 | 14 | 23 | 18 | 14 | 22 | 25 | 26 | 13 | 30 | 5 |
| 3 | 9 | 7 | 0 | 11 | 18 | 15 | 2 | 19 | 15 | 23 | 27 | 27 | 30 | 31 | 4 |

or when K is equal to 8, the first interleaving pattern is shown in Table #28:

Table #28

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 15 | 8 | 31 | 12 | 27 | 16 | 1 | 20 | 29 | 24 | 12 | 28 | 9 |
| 1 | 17 | 5 | 10 | 9 | 18 | 13 | 7 | 17 | 20 | 21 | 4 | 25 | 13 | 29 | 5 |
| 2 | 16 | 6 | 8 | 10 | 6 | 14 | 26 | 18 | 3 | 22 | 0 | 26 | 14 | 30 | 19 |
| 3 | 28 | 7 | 2 | 11 | 11 | 15 | 22 | 19 | 23 | 23 | 21 | 27 | 25 | 31 | 24 |

or when K is equal to 9, the first interleaving pattern is shown in Table #29:

Table #29

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 7 | 8 | 1 | 12 | 3 | 16 | 27 | 20 | 20 | 24 | 18 | 28 | 9 |
| 1 | 16 | 5 | 23 | 9 | 0 | 13 | 8 | 17 | 28 | 21 | 4 | 25 | 22 | 29 | 24 |
| 2 | 12 | 6 | 6 | 10 | 31 | 14 | 29 | 18 | 15 | 22 | 19 | 26 | 14 | 30 | 13 |
| 3 | 10 | 7 | 21 | 11 | 26 | 15 | 17 | 19 | 5 | 23 | 11 | 27 | 2 | 31 | 25 |

or when K is equal to 10, the first interleaving pattern is shown in Table #30:

Table #30

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 16 | 4 | 25 | 8 | 3 | 12 | 23 | 16 | 7 | 20 | 21 | 24 | 29 | 28 | 28 |
| 1 | 15 | 5 | 24 | 9 | 1 | 13 | 0 | 17 | 19 | 21 | 6 | 25 | 14 | 29 | 9 |
| 2 | 11 | 6 | 8 | 10 | 20 | 14 | 13 | 18 | 2 | 22 | 30 | 26 | 27 | 30 | 18 |
| 3 | 10 | 7 | 4 | 11 | 26 | 15 | 5 | 19 | 12 | 23 | 31 | 27 | 22 | 31 | 17 |

or when K is equal to 11, the first interleaving pattern is shown in Table #31:

Table #31

| i | P(i) | i | P(i) | i | P(i) | i | P(i) | i | P(i) | i | P(i) | i | P(i) | i | P(i) |
|---|------|---|------|---|------|----|------|----|------|----|------|----|------|----|------|
| 0 | 30 | 4 | 27 | 8 | 4 | 12 | 7 | 16 | 10 | 20 | 24 | 24 | 23 | 28 | 5 |
| 1 | 29 | 5 | 19 | 9 | 21 | 13 | 12 | 17 | 16 | 21 | 31 | 25 | 9 | 29 | 17 |
| 2 | 18 | 6 | 6 | 10 | 20 | 14 | 25 | 18 | 14 | 22 | 8 | 26 | 3 | 30 | 11 |
| 3 | 15 | 7 | 22 | 11 | 0 | 15 | 13 | 19 | 28 | 23 | 1 | 27 | 2 | 31 | 26 |

i represents an $(i+1)^{th}$ row in the first encoding sequence code, P(i) represents a row element that is in a $(P(i)+1)^{th}$ row in the first encoding sequence and that is placed in an $(i+1)^{th}$ row in the second encoding sequence, and $0 \leq i \leq 31$.

According to a third aspect, a communication apparatus is provided. The communication apparatus has a function of implementing the method according to any one of the first aspect or the possible implementations of the first aspect. The function may be implemented by hardware, or may be implemented by hardware executing corresponding software. The hardware or the software includes one or more units corresponding to the function.

According to a fourth aspect, a communication apparatus is provided. The communication apparatus has a function of implementing the method according to any one of the second aspect or the possible implementations of the second aspect. The function may be implemented by hardware, or may be implemented by hardware executing corresponding software. The hardware or the software includes one or more units corresponding to the function.

According to a fifth aspect, a communication apparatus is provided, and includes a processor and a memory. Optionally, the communication apparatus may further include a transceiver. The memory is configured to store a computer program, and the processor is configured to: invoke and run the computer program stored in the memory, and control the transceiver to receive and send a signal, to enable the communication apparatus to perform the method according to any one of the first aspect or the possible implementations of the first aspect.

According to a sixth aspect, a communication apparatus is provided, and includes a processor and a memory. Optionally, the communication apparatus may further include a transceiver. The memory is configured to store a computer program, and the processor is configured to: invoke and run the computer program stored in the memory, and control the transceiver to receive and send a signal, to enable the communication apparatus to perform the method according to any one of the second aspect or the possible implementations of the second aspect.

According to a seventh aspect, a communication apparatus is provided, and includes a processor and a communication interface. The communication interface is configured to: receive data and/or information, and transmit the received data and/or information to the processor, the processor processes the data and/or information, and the communication interface is further configured to output data and/or information obtained through processing by the processor, so that the method according to any one of the first aspect or the possible implementations of the first aspect is performed.

According to an eighth aspect, a communication apparatus is provided, and includes a processor and a communication interface. The processor processes to-be-sent data and/or information, and the communication interface is further configured to output data and/or information obtained through processing by the processor, so that the method according to any one of the second aspect or the possible implementations of the second aspect is performed.

According to a ninth aspect, a computer-readable storage medium is provided. The computer-readable storage medium stores computer instructions. When the computer instructions are run on a computer, the method according to any one of the first aspect, the second aspect, or the possible implementations of the aspects is performed.

According to a tenth aspect, a computer program product is provided. The computer program product includes computer program code. When the computer program code is run on a computer, the method according to any one of the first aspect, the second aspect, or the possible implementations of the aspects is performed.

According to an eleventh aspect, a communication system is provided, and includes the communication apparatus according to the fifth aspect or the communication apparatus according to the sixth aspect.

**BRIEF DESCRIPTION OF DRAWINGS**

FIG. 1 is a diagram of a system architecture of a communication system applicable to technical solutions of this application;
FIG. 2 is a schematic flowchart of a rate matching method 200 according to this application;
FIG. 3 is a diagram of a search algorithm for determining a K nested puncturing sequence according to this application;
FIG. 4 is a schematic flowchart of another rate matching method 400 according to this application;

FIG. 5 is a simulation comparison diagram of performance corresponding to four different rate matching methods when K=11;

FIG. 6 is a block diagram of a communication apparatus 600 according to this application; and

FIG. 7 is a diagram of a structure of a communication apparatus 700 according to this application.

## DESCRIPTION OF EMBODIMENTS

The following describes technical solutions of this application with reference to accompanying drawings.

The technical solutions in embodiments of this application may be applied to various communication systems, including but not limited to a satellite communication system, a 5th generation (5th generation, 5G) system, a long term evolution (long term evolution, LTE) system (LTE frequency division duplex (frequency division duplex, FDD) system, an LTE time division duplex (time division duplex, TDD) system), and the like. The technical solutions provided in this application may be further applied to a future communication system, for example, a 6th generation mobile communication system. In addition, the technical solutions may be further applied to device-to-device (device-to-device, D2D) communication, vehicle-to-everything (vehicle-to-everything, V2X) communication, machine-to-machine (machine-to-machine, M2M) communication, machine type communication (machine type communication, MTC), an internet of things (internet of things, IoT) communication system, another communication system, and the like. This is not limited in this specification.

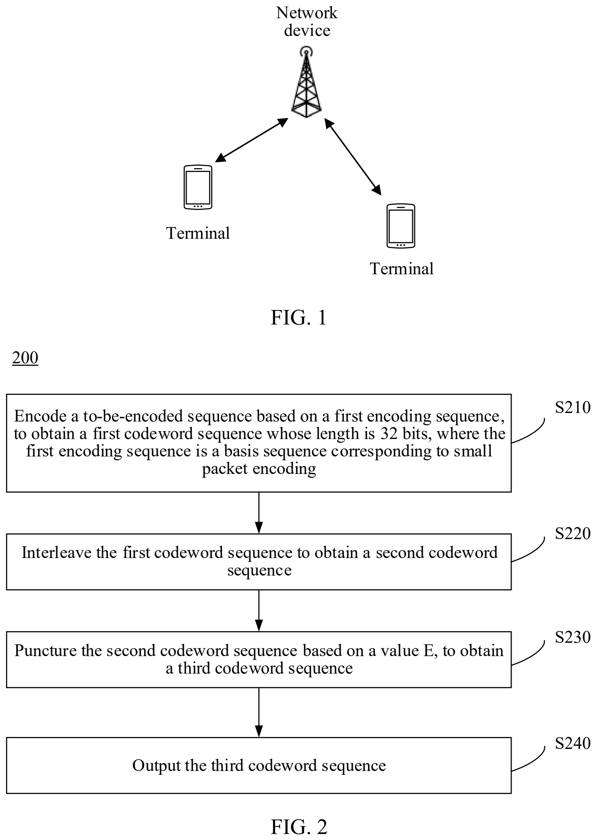

FIG. 1 is a diagram of a system architecture of a communication system applicable to technical solutions of this application. The communication system may include one or more network devices and one or more terminal devices.

For example, the terminal device may also be referred to as a user equipment (user equipment, UE), an access terminal, a subscriber unit, a subscriber station, a mobile station, a mobile terminal (mobile terminal, MT), a remote station, a remote terminal, a mobile device, a user terminal, a terminal, a wireless communication device, a user agent, or a user apparatus. The terminal device in embodiments of this application may be a device that provides voice and/or data connectivity for a user, and may be configured to connect a person, an object, and a machine, for example, a handheld device or a vehicle-mounted device having a wireless connection function. The terminal device in embodiments of this application may be a mobile phone (mobile phone), a tablet (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like. Optionally, the UE may serve as a base station. For example, the UE may serve as a scheduling entity that provides a sidelink signal between UEs in V2X, D2D, or the like.

In embodiments of this application, an apparatus configured to implement a function of a terminal may be a terminal, or may be an apparatus that can support the terminal in implementing the function, for example, a chip system or a chip. The apparatus may be mounted in the terminal. In embodiments of this application, the chip system may include a chip, or may include a chip and another discrete component.

For example, the network device may be a device having a wireless transceiver function. The network device may be a device providing a wireless communication function service, and is usually located on a network side, including but not limited to a next generation NodeB (gNodeB, gNB) in a 5th generation (5th generation, 5G) communication system, a base station in a 6th generation (6th generation, 6G) mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB or a home NodeB, HNB), a baseband unit (baseband unit, BBU), a transmission reception point (transmission reception point, TRP), a transmission point (transmission point, TP), a base transceiver station (base transceiver station, BTS), and the like. In a network structure, the network device may include a central unit (central unit, CU) node, a distributed unit (distributed unit, DU) node, a RAN device including a CU node and a DU node, or a RAN device including a CU-control plane node, a CU-user plane node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip arranged in the foregoing device or apparatus. The base station may alternatively be a mobile switching center, a device that bears a base station function in D2D, V2X, and M2M communication, a network side device in a 6G network, a device that bears a base station function in a future communication system, or the like. The base station can support networks using a same access technology or different access technologies. This is not limited.

In embodiments of this application, an apparatus configured to implement a function of the network device may be a network device, or may be an apparatus that can support the network device in implementing the function, for example, a chip system or a chip. The apparatus may be mounted in the network device. In embodiments of this application, the chip system may include a chip, or may include a chip and another discrete component.

It should be understood that the rate matching method provided in this application may be considered as a channel coding scheme, may be applied to a dedicated network device or a general-purpose device, and may be applied to various network devices (for example, a base station device) described above, or may be applied to various terminal devices described above. Specifically, the channel coding scheme is mainly implemented by a channel coding unit in these devices.

The method provided in embodiments of this application may be alternatively implemented by using an application-specific integrated circuit (application-specific integrated circuit, ASIC), a field programmable gate array (field programmable gate array, FPGA), or the like, or may be implemented by using software (for example, program code in a memory). This is not limited.

LTE-RM code is a method for encoding a small packet (or referred to as a very short message or a small block) of 3 bits to 11 bits. A specific encoding process is as follows. It is assumed that a small packet sequence/a very short message sequence before encoding is $c_0$, $c_1$, ..., and $c_{K-1}$ ($3 \leq K \leq 11$), and the small packet sequence/the very short message sequence is encoded based on basis sequences for (32, K) code (basis sequences for (32, K) code) shown in Table 1, where i represents a row index of a matrix, M represents that a codeword sequence after encoding of a column index of the matrix is $d_0$, $d_1$, ..., $d_{N-1}$, N=32, $d_i = \left( \sum_{k=0}^{K-1} c_k M_{i,k} \right) mod 2$ , and $i = 0$, 1, 2, ..., and N-1.

Table 1

| i | $M_{i,0}$ | $M_{i,1}$ | $M_{i,2}$ | $M_{i,3}$ | $M_{i,4}$ | $M_{i,6}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 0 | 0 | 0 | 0 | 0 | 0 | 0 | 0 | 1 |
| 1 | 1 | 1 | 1 | 0 | 0 | 0 | 0 | 0 | 0 | 1 | 1 |
| 2 | 1 | 0 | 0 | 1 | 0 | 0 | 1 | 0 | 1 | 1 | 1 |
| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
| 3 | 1 | 0 | 1 | 1 | 0 | 0 | 0 | 0 | 1 | 0 | 1 |
| 4 | 1 | 1 | 1 | 1 | 0 | 0 | 0 | 1 | 0 | 0 | 1 |
| 5 | 1 | 1 | 0 | 0 | 1 | 0 | 1 | 1 | 1 | 0 | 1 |
| 6 | 1 | 0 | 1 | 0 | 1 | 0 | 1 | 0 | 1 | 1 | 1 |
| 7 | 1 | 0 | 0 | 1 | 1 | 0 | 0 | 1 | 1 | 0 | 1 |
| 8 | 1 | 1 | 0 | 1 | 1 | 0 | 0 | 1 | 0 | 1 | 1 |
| 9 | 1 | 0 | 1 | 1 | 1 | 0 | 1 | 0 | 0 | 1 | 1 |
| 10 | 1 | 0 | 1 | 0 | 0 | 1 | 1 | 1 | 0 | 1 | 1 |
| 11 | 1 | 1 | 1 | 0 | 0 | 1 | 1 | 0 | 1 | 0 | 1 |
| 12 | 1 | 0 | 0 | 1 | 0 | 1 | 0 | 1 | 1 | 1 | 1 |
| 13 | 1 | 1 | 0 | 1 | 0 | 1 | 0 | 1 | 0 | 1 | 1 |
| 14 | 1 | 0 | 0 | 0 | 1 | 1 | 0 | 1 | 0 | 0 | 1 |
| 15 | 1 | 1 | 0 | 0 | 1 | 1 | 1 | 1 | 0 | 1 | 1 |
| 16 | 1 | 1 | 1 | 0 | 1 | 1 | 1 | 0 | 0 | 1 | 0 |
| 17 | 1 | 0 | 0 | 1 | 1 | 1 | 0 | 0 | 1 | 0 | 0 |
| 18 | 1 | 1 | 0 | 1 | 1 | 1 | 1 | 1 | 0 | 0 | 0 |
| 19 | 1 | 0 | 0 | 0 | 0 | 1 | 1 | 0 | 0 | 0 | 0 |
| 20 | 1 | 0 | 1 | 0 | 0 | 0 | 1 | 0 | 0 | 0 | 1 |
| 21 | 1 | 1 | 0 | 1 | 0 | 0 | 0 | 0 | 0 | 1 | 1 |
| 22 | 1 | 0 | 0 | 0 | 1 | 0 | 0 | 1 | 1 | 0 | 1 |
| 23 | 1 | 1 | 1 | 0 | 1 | 0 | 0 | 0 | 1 | 1 | 1 |
| 24 | 1 | 1 | 1 | 1 | 1 | 0 | 1 | 1 | 1 | 1 | 0 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 25 | 1 | 1 | 0 | 0 | 0 | 1 | 1 | 1 | 0 | 0 | 1 |
| 26 | 1 | 0 | 1 | 1 | 0 | 1 | 0 | 0 | 1 | 1 | 0 |
| 27 | 1 | 1 | 1 | 1 | 0 | 1 | 0 | 1 | 1 | 1 | 0 |
| 28 | 1 | 0 | 1 | 0 | 1 | 1 | 1 | 0 | 1 | 0 | 0 |
| 29 | 1 | 0 | 1 | 1 | 1 | 1 | 1 | 1 | 1 | 0 | 0 |
| 30 | 1 | 1 | 1 | 1 | 1 | 1 | 1 | 1 | 1 | 1 | 1 |
| 31 | 1 | 0 | 0 | 0 | 0 | 0 | 0 | 0 | 0 | 0 | 0 |

When a length (that is, a code length) E of an actually transmitted codeword sequence after encoding is not equal to a length N of the encoded codeword sequence $d_0, d_1, ..., d_{N-1}$, an existing rate matching manner is that an input sequence for rate matching is the encoded codeword sequence $d_0, d_1, ..., d_{N-1}$, and an output codeword sequence for rate matching is $f_0, f_1, ..., f_{E-1}$, where E indicates a length (that is, a code length) of an actually sent codeword sequence after rate matching. The sequence $f_0, f_1, ..., f_{E-1}$ is obtained in the following manner:

$$\text{for k=0 to E}-1$$
$$f_k = d_{k \bmod N};$$
$$\text{end for}$$

Based on the foregoing manner, the existing rate matching manner may be understood as follows:

1. When E is less than N, the codeword sequence $d_0, d_1, ..., d_{N-1}$ is punctured from back to front. Specifically, bits in consecutive (32-E) bit positions are punctured starting from the last bit position of the codeword sequence $d_0, d_1, ..., d_{N-1}$ toward the front. For example, when E=30, a codeword sequence that is output after rate matching is $d_0, d_1, ..., d_{N-3}$.
It should be noted that, if a length of the very short message sequence before encoding is K, when the transmission code length E is less than N, a smallest value of the transmission code length E is K+1.

2. When E is greater than N, the codeword sequence $d_0, d_1, ..., d_{N-1}$ is repeated from front to back until a code length of an obtained codeword sequence is E. For example, E is equal to 2N. In this case, the codeword sequence output after rate matching is $d_0, d_1, ..., d_{N-1}, d_0, d_1, ..., d_{N-1}$.

When E is less than N, if a value of E is small, that is, if a quantity of punctured bits is large, a performance bad point occurs, resulting in poor decoding performance. For example, the performance bad point occurs when K=6 and E=7. The performance bad point specifically refers to a codeword sequence whose length is 7 and that is output based on the foregoing rate matching manner when K=6 and E=7. As a signal-to-noise ratio (signal-to-noise ratio, SNR) continuously increases, a block error rate (block error rate, BLER) of the codeword sequence cannot decrease to 0.01.

In view of this, this application provides a rate matching method, to resolve the foregoing technical problems. The following describes in detail the method provided in this application with reference to FIG. 2.

FIG. 2 is a schematic flowchart of a rate matching method 200 according to this application. The method includes the following steps.

S210: A first device encodes a to-be-encoded sequence based on a first encoding sequence, to obtain a first codeword sequence whose length is 32 bits, where the first encoding sequence is a basis sequence corresponding to small packet encoding.

The basis sequence corresponding to the small packet encoding in this application may also be referred to as a basis sequence for (32, K) code, where 32 represents a length of an encoded sequence, and K represents a length of the to-be-encoded sequence. Therefore, the small packet encoding may be understood as encoding a sequence whose length is K, where 3≤K≤11.

In a possible implementation, the first encoding sequence is the encoding sequences shown in Table 1. For how to generate the first codeword sequence based on the encoding sequences shown in Table 1, refer to the foregoing descriptions. Details are not described herein again.

S220: The first device interleaves the first codeword sequence to obtain a second codeword sequence.

Interleaving the first codeword sequence specifically refers to adjusting positions of all or a part of bits in the 32 bits in the first codeword sequence. When positions of at least two bits in the 32 bits in the first codeword sequence change, it may be considered that interleaving is performed on the first codeword. It should be noted that, an interleaving operation is merely to adjust a bit position in the first codeword sequence. Therefore, a code length of the second codeword sequence is also 32.

Optionally, that the first device interleaves the first codeword sequence includes: The first device interleaves the first codeword sequence based on a first interleaving pattern (first interleaving pattern), where the first interleaving pattern is used for resetting the positions of the 32 bits in the first codeword sequence.

For example, when the first encoding sequence is the encoding sequences shown in Table 1, the first interleaving pattern is shown in Table 2, where i represents an $(i+1)^{th}$ position of the second codeword sequence, and P(i) represents a bit that is in a $(P(i)+1)^{th}$ position of the first codeword sequence and that is placed in the $(i+1)^{th}$ position of the second codeword sequence.

Table 2

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 17 | 8 | 28 | 12 | 5 | 16 | 26 | 20 | 24 | 24 | 31 | 28 | 6 |
| 1 | 13 | 5 | 15 | 9 | 18 | 13 | 23 | 17 | 2 | 21 | 16 | 25 | 9 | 29 | 14 |
| 2 | 22 | 6 | 4 | 10 | 19 | 14 | 10 | 18 | 29 | 22 | 7 | 26 | 11 | 30 | 27 |
| 3 | 3 | 7 | 1 | 11 | 12 | 15 | 25 | 19 | 21 | 23 | 20 | 27 | 0 | 31 | 8 |

Specifically, the first codeword sequence obtained by encoding the to-be-encoded sequence based on the encoding sequences shown in Table 1 is $d_0, d_1, ..., d_{N-1}$, where N=32; and the second codeword sequence is $e_0, e_1, e_2, ..., e_{N-1}$, which is obtained in the following manner:

$$\text{for } n=0 \text{ to } N-1$$

$$e_n = d_{P(n)}$$

$$\text{end for}$$

Optionally, the first interleaving pattern indicates bits in last M bit positions in the second codeword sequence obtained by interleaving the first codeword sequence based on the first interleaving pattern, which are the same as bits in last M bit positions in the first codeword sequence. For example, M=12. When the first codeword sequence is punctured, a performance bad point occurs only when a quantity of punctured bits exceeds 12. Therefore, the bits in the last M bit positions in the second codeword sequence may be the same as bits in last 12 bit positions in the first codeword sequence. That is, interleaving is performed only in 1st 20 positions of the first codeword sequence.

For example, when the first encoding sequence is the encoding sequences shown in Table 1, M=12, and the first interleaving pattern is shown in Table 3. i in the first interleaving pattern represents an $(i+1)^{th}$ position of the second codeword sequence, and P(i) represents a bit that is in a $(P(i)+1)^{th}$ position of the first codeword sequence and that is placed in the $(i+1)^{th}$ position of the second codeword sequence. When M=12, and i=20 to 31, correspondingly, P(i) is equal to i.

Table 3

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 16 | 4 | 4 | 8 | 15 | 12 | 10 | 16 | 12 | 20 | 20 | 24 | 24 | 28 | 28 |
| 1 | 14 | 5 | 7 | 9 | 1 | 13 | 17 | 17 | 11 | 21 | 21 | 25 | 25 | 29 | 29 |
| 2 | 3 | 6 | 9 | 10 | 8 | 14 | 5 | 18 | 2 | 22 | 22 | 26 | 26 | 30 | 30 |
| 3 | 0 | 7 | 6 | 11 | 13 | 15 | 19 | 19 | 18 | 23 | 23 | 27 | 27 | 31 | 31 |

It may be understood that the second codeword sequence is determined based on the first interleaving pattern. When the second codeword sequence needs to be punctured, puncturing needs to be performed from back to front. Therefore, the first interleaving pattern in this application may also be understood as a puncturing sequence. In this application, the puncturing sequence and the interleaving pattern are interchangeable.

When E is small, if the first codeword sequence is directly punctured from back to front for (32-E) times, a performance bad point may occur on an output sequence after rate matching. However, the first codeword sequence is interleaved based on Table 2 and Table 3 to obtain the second codeword sequence, and then the second codeword sequence is punctured from back to front for (32-E) times, so that it can be ensured that the output sequence (that is, a third codeword sequence) after rate matching has no performance bad point.

It should be noted that the first interleaving patterns corresponding to Table 2 and Table 3 are K nested puncturing sequences. The K nested puncturing sequence means that rate matching is performed on a plurality of to-be-encoded sequences of different lengths by using a same puncturing sequence. The plurality of to-be-encoded sequences of different lengths are sequences whose lengths are 3 to 11.

For example, when the first encoding sequence is the encoding sequences shown in Table 1, Table 4 to Table 12 provide K non-nested puncturing sequences. The K non-nested puncturing sequence means that rate matching is performed on a plurality of to-be-encoded sequences of different lengths by using respective puncturing sequences. Specifically, Table 4 is a puncturing sequence of a to-be-encoded sequence whose length is 3, and Table 5 is a puncturing sequence of a to-be-encoded sequence whose length is 4. The rest can be deduced by analogy. Table 11 is a puncturing sequence of a to-be-encoded sequence whose length is 10, and Table 12 is a puncturing sequence of a to-be-encoded sequence whose length is 11.

Table 4

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 28 | 4 | 22 | 8 | 2 | 12 | 1 | 16 | 4 | 20 | 27 | 24 | 18 | 28 | 10 |
| 1 | 14 | 5 | 16 | 9 | 29 | 13 | 31 | 17 | 13 | 21 | 17 | 25 | 9 | 29 | 11 |
| 2 | 25 | 6 | 8 | 10 | 30 | 14 | 15 | 18 | 3 | 22 | 6 | 26 | 24 | 30 | 5 |
| 3 | 23 | 7 | 26 | 11 | 21 | 15 | 20 | 19 | 12 | 23 | 19 | 27 | 0 | 31 | 7 |

Table 5

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 20 | 8 | 6 | 12 | 12 | 16 | 13 | 20 | 9 | 24 | 28 | 28 | 7 |
| 1 | 29 | 5 | 14 | 9 | 3 | 13 | 25 | 17 | 0 | 21 | 4 | 25 | 27 | 29 | 5 |
| 2 | 21 | 6 | 15 | 10 | 24 | 14 | 23 | 18 | 11 | 22 | 31 | 26 | 26 | 30 | 18 |
| 3 | 1 | 7 | 17 | 11 | 19 | 15 | 8 | 19 | 22 | 23 | 2 | 27 | 16 | 31 | 10 |

Table 6

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 4 | 8 | 3 | 12 | 16 | 16 | 25 | 20 | 24 | 24 | 21 | 28 | 15 |
| 1 | 17 | 5 | 0 | 9 | 13 | 13 | 10 | 17 | 6 | 21 | 27 | 25 | 19 | 29 | 7 |
| 2 | 14 | 6 | 5 | 10 | 11 | 14 | 29 | 18 | 23 | 22 | 9 | 26 | 26 | 30 | 12 |
| 3 | 8 | 7 | 28 | 11 | 2 | 15 | 31 | 19 | 1 | 23 | 18 | 27 | 22 | 31 | 20 |

Table 7

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 29 | 4 | 7 | 8 | 25 | 12 | 5 | 16 | 3 | 20 | 20 | 24 | 22 | 28 | 10 |
| 1 | 16 | 5 | 21 | 9 | 4 | 13 | 6 | 17 | 15 | 21 | 8 | 25 | 13 | 29 | 19 |
| 2 | 26 | 6 | 1 | 10 | 28 | 14 | 9 | 18 | 14 | 22 | 2 | 26 | 31 | 30 | 27 |
| 3 | 24 | 7 | 0 | 11 | 30 | 15 | 17 | 19 | 12 | 23 | 23 | 27 | 18 | 31 | 11 |

Table 8

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 17 | 4 | 22 | 8 | 1 | 12 | 7 | 16 | 19 | 20 | 29 | 24 | 20 | 28 | 28 |
| 1 | 26 | 5 | 3 | 9 | 8 | 13 | 12 | 17 | 31 | 21 | 6 | 25 | 16 | 29 | 11 |
| 2 | 24 | 6 | 21 | 10 | 10 | 14 | 23 | 18 | 14 | 22 | 25 | 26 | 13 | 30 | 5 |
| 3 | 9 | 7 | 0 | 11 | 18 | 15 | 2 | 19 | 15 | 23 | 27 | 27 | 30 | 31 | 4 |

Table 9

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 15 | 8 | 31 | 12 | 27 | 16 | 1 | 20 | 29 | 24 | 12 | 28 | 9 |
| 1 | 17 | 5 | 10 | 9 | 18 | 13 | 7 | 17 | 20 | 21 | 4 | 25 | 13 | 29 | 5 |
| 2 | 16 | 6 | 8 | 10 | 6 | 14 | 26 | 18 | 3 | 22 | 0 | 26 | 14 | 30 | 19 |
| 3 | 28 | 7 | 2 | 11 | 11 | 15 | 22 | 19 | 23 | 23 | 21 | 27 | 25 | 31 | 24 |

Table 10

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 7 | 8 | 1 | 12 | 3 | 16 | 27 | 20 | 20 | 24 | 18 | 28 | 9 |
| 1 | 16 | 5 | 23 | 9 | 0 | 13 | 8 | 17 | 28 | 21 | 4 | 25 | 22 | 29 | 24 |
| 2 | 12 | 6 | 6 | 10 | 31 | 14 | 29 | 18 | 15 | 22 | 19 | 26 | 14 | 30 | 13 |
| 3 | 10 | 7 | 21 | 11 | 26 | 15 | 17 | 19 | 5 | 23 | 11 | 27 | 2 | 31 | 25 |

Table 11

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 16 | 4 | 25 | 8 | 3 | 12 | 23 | 16 | 7 | 20 | 21 | 24 | 29 | 28 | 28 |
| 1 | 15 | 5 | 24 | 9 | 1 | 13 | 0 | 17 | 19 | 21 | 6 | 25 | 14 | 29 | 9 |
| 2 | 11 | 6 | 8 | 10 | 20 | 14 | 13 | 18 | 2 | 22 | 30 | 26 | 27 | 30 | 18 |
| 3 | 10 | 7 | 4 | 11 | 26 | 15 | 5 | 19 | 12 | 23 | 31 | 27 | 22 | 31 | 17 |

Table 12

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 27 | 8 | 4 | 12 | 7 | 16 | 10 | 20 | 24 | 24 | 23 | 28 | 5 |
| 1 | 29 | 5 | 19 | 9 | 21 | 13 | 12 | 17 | 16 | 21 | 31 | 25 | 9 | 29 | 17 |
| 2 | 18 | 6 | 6 | 10 | 20 | 14 | 25 | 18 | 14 | 22 | 8 | 26 | 3 | 30 | 11 |
| 3 | 15 | 7 | 22 | 11 | 0 | 15 | 13 | 19 | 28 | 23 | 1 | 27 | 2 | 31 | 26 |

Table 4 to Table 12 may be E nested puncturing sequences when K is not nested. FIG. 12 corresponding to K=11 is used as an example. The E nested puncturing sequence is a same puncturing sequence used when $12 \leq E \leq 31$. It can be learned from the foregoing descriptions that, when the length of the to-be-encoded sequence is K, a smallest value of a length E of the third codeword sequence after rate matching is K+1. In other words, when E=K+1, a quantity (32-K-1) of to-be-punctured bits is a largest quantity of to-be-punctured bits. For example, Table 12 is used as an example. K=11, and a smallest value 12 is used for E. That is, a quantity of to-be-punctured bits is a largest quantity 20 of to-be-punctured bits. If the obtained first codeword sequence is punctured from back to front for 20 times, a performance bad point occurs on an output sequence after rate matching. However, in this application, interleaving is performed on the first codeword sequence based on Table 12, to obtain the second codeword sequence, and puncturing is performed on the second codeword sequence from back to front for 20 times. This can ensure that the output sequence (that is, the third codeword sequence) after rate matching has no performance bad point. Specifically, based on Table 12, bits in positions 7, 12, 25, ..., 17, 11, and 26 in the first codeword sequence may be respectively placed in 20 positions for which i is equal to 12 to 31 in the second codeword sequence. In addition, bit values in remaining 12 positions in the first codeword sequence may be placed in 12 positions for which i is equal to 0 to 11 in one-to-one correspondence in the second codeword sequence, and a placement order of the bit values in the remaining 12 positions is not limited in this application. However, it should be noted that, although the order of the remaining 12 positions is not limited, specific values of P(i) corresponding to i=0 to 11 still need to be provided in an actual application of Table 12. That is, Table 12 merely provides the specific values of P(i) corresponding to i=0 to 11. Other tables in this application are similar to Table 12, and details are not described below again.

Still using K=11 as an example, when 12<E<32, a largest quantity of to-be-punctured bits is 20. That is, a quantity of to-be-punctured bits when rate matching is performed is less than 20. Therefore, puncturing may be performed based on Table 12. Alternatively, because quantities of bits that need to be punctured when rate matching is performed are different based on different values of E, an interleaving pattern corresponding to each value of E may be provided based on Table 12 for puncturing. For example, when E is not nested, E=18 is used as an example. A quantity of to-be-punctured bits is 14, and a corresponding first interleaving pattern is shown in Table 13. Other examples are not described herein again.

Table 13

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | / | 4 | / | 8 | / | 12 | / | 16 | / | 20 | 24 | 24 | 23 | 28 | 5 |
| 1 | / | 5 | / | 9 | / | 13 | / | 17 | / | 21 | 31 | 25 | 9 | 29 | 17 |
| 2 | / | 6 | / | 10 | / | 14 | / | 18 | 14 | 22 | 8 | 26 | 3 | 30 | 11 |
| 3 | / | 7 | / | 11 | / | 15 | / | 19 | 28 | 23 | 1 | 27 | 2 | 31 | 26 |

In other words, when K=11 and E=18, based on Table 13, bits in positions 25, 27, 16, ..., 29, 20, and 23 in the first codeword sequence may be respectively placed in 14 positions for which i is equal to 18 to 31 in the second codeword sequence. In addition, bits in remaining 18 positions in the first codeword sequence may be placed in 18 positions for which i is equal to 0 to 17 in the second codeword sequence in one-to-one correspondence, and a placement order of the bits in the remaining 18 positions is not limited in this application. Similarly, although the order of the remaining 18 positions is not limited, specific values of P(i) corresponding to i=0 to 17 still need to be provided in an actual application of Table 13. "/" herein represents that an order is not limited, and does not indicate that P(i) corresponding to i=0 to 17 does not exist. In this application, "/" in other interleaving patterns indicates a same meaning, and details are not described again.

S230: The first device punctures the second codeword sequence based on the value E, to obtain the third codeword sequence, where the value E indicates a quantity of bits of the second codeword sequence after rate matching, and E is a positive integer less than 32.

It may be understood that the second codeword sequence is an input sequence for rate matching, and the third codeword sequence is an output sequence for rate matching. For a rate matching manner, refer to the foregoing descriptions of the current rate matching manner. Details are not described herein again.

For example, the first interleaving pattern is shown in Table 2, and a second codeword is obtained by interleaving the first codeword sequence based on Table 2. When E=14, rate matching is performed, and the second codeword sequence is sequentially punctured from back to front for 18 times, to be specific, bits in positions {8,27,14,6,0,11,9,31,20,7,16,24,21,29,2,26,25,10} of the first codeword sequence are punctured, to obtain the third codeword sequence. For another example, when E=22, rate matching is performed, and the second codeword sequence is sequentially punctured from back to front for 10 times, to be specific, bits in positions {8,27,14,6,0,11,9,31,20,7} of the first codeword sequence are punctured, to obtain the third codeword sequence. It should be understood that, in the foregoing descriptions, puncturing a bit in a $0^{th}$ position of the first codeword sequence may be understood as puncturing a bit in a start position of the first codeword sequence, and puncturing a bit in a $1^{st}$ position of the first codeword sequence may be understood as puncturing a bit in a $1^{st}$ position after the start position of the first codeword sequence. The rest can be deduced by analogy. Puncturing a bit in a $30^{th}$ position of the first codeword sequence may be understood as puncturing a bit in a penultimate position of the first codeword sequence, and puncturing a bit in a $31^{st}$ position of the first codeword sequence may be understood as puncturing a bit in a last position of the first codeword sequence. The same descriptions are not provided in the following.

S240: The first device outputs the third codeword sequence.

In the foregoing technical solution, before rate matching is performed on the first codeword sequence, the first codeword sequence is first interleaved based on the first encoding sequence, so that a code distance characteristic of a punctured first codeword sequence can be improved, and a Hamming distance between different valid codewords is as large as possible. In this way, a probability that a decoder incorrectly decodes a valid codeword into another valid codeword is reduced. That is, decoding performance is improved. A code distance refers to a Hamming distance between two codewords. For example, a codeword whose length is 4 and that is obtained by encoding a message 1 (that is, a to-be-encoded sequence #1) is C1=[0 0 0 0], and another codeword whose length is 4 and that is obtained by encoding a message 2 (that is, a to-be-encoded sequence #2) is C2=[0 0 1 1]. In this case, a code distance between the two codewords is a quantity of different elements in corresponding positions in C1 and C2, and the code distance between C1 and C2 is 2. It is assumed that interleaving is not performed before puncturing, and puncturing is directly performed from back to front. If puncturing is performed in two positions, corresponding codewords obtained by puncturing C1 and C2 are C1'=[0 0] and C2'=[0 0], the code distance between the two codewords after puncturing is 0, and the two codewords are completely the same. Therefore, a decoder cannot distinguish whether the message 1 or the message 2 is sent by a transmitter. However, if C1 and C2 are interleaved, and 1st two elements are interleaved to 3rd and 4th positions, C1 becomes [0 0 0 0], and C2 becomes [1 1 0 0]. Then, puncturing is performed in two positions from back to front, so that C1"=[0 0], C2"=[1 1], and the code distance after puncturing is 2. In this way, the decoder can easily distinguish whether the message 1 or the message 2 is sent by the transmitter, thereby improving decoding performance after puncturing.

Based on the method shown in FIG. 2, in another possible implementation, the first encoding sequence is encoding sequences shown in Table 14, and the encoding sequences are a matrix with 32 rows and 11 columns, where i represents a row index of the matrix, and M represents a column index of the matrix. For example, a to-be-encoded sequence is $c_0$, $c_1$, ..., $c_{K-1}$ ($3 \leq K \leq 11$), and a codeword sequence obtained through encoding based on the encoding sequence shown in Table 13 is $d_0$, $d_1$,..., $d_{N-1}$, where N=32, $d_i = \left( \sum_{k=0}^{K-1} c_k M_{i,k} \right)$, i =0, 1, 2, ..., N-1. Specifically, the encoding sequence may be an encoding sequence obtained by performing row interleaving on the encoding sequences shown in Table 1, and elements corresponding to 32 rows and 1st six columns in the encoding sequence form first-order RM code. First RM code means that, in the encoding matrix, a 1st column is an all-1 column, a 2nd column is a column in which one 0 and one 1 are alternately arranged, a 3rd column is a column in which two 0s and two 1s are alternately arranged, a 4th column is a column in which four 0s and four 1s are alternately arranged, a 5th column is a column in which eight 0s and eight 1s are alternately arranged, and a 6th column is a column in which sixteen 0s and sixteen 1s are alternately arranged.

Table 14

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 0 | 0 | 0 | 0 | 0 | 0 | 0 | 0 | 0 | 0 |
| 1 | 1 | 1 | 0 | 0 | 0 | 0 | 0 | 0 | 0 | 0 | 1 |
| 2 | 1 | 0 | 1 | 0 | 0 | 0 | 1 | 0 | 0 | 0 | 1 |
| 3 | 1 | 1 | 1 | 0 | 0 | 0 | 0 | 0 | 0 | 1 | 1 |
| 4 | 1 | 0 | 0 | 1 | 0 | 0 | 1 | 0 | 1 | 1 | 1 |
| 5 | 1 | 1 | 0 | 1 | 0 | 0 | 0 | 0 | 0 | 1 | 1 |
| 6 | 1 | 0 | 1 | 1 | 0 | 0 | 0 | 0 | 1 | 0 | 1 |
| 7 | 1 | 1 | 1 | 1 | 0 | 0 | 0 | 1 | 0 | 0 | 1 |
| 8 | 1 | 0 | 0 | 0 | 1 | 0 | 0 | 1 | 1 | 0 | 1 |
| 9 | 1 | 1 | 0 | 0 | 1 | 0 | 1 | 1 | 1 | 0 | 1 |
| 10 | 1 | 0 | 1 | 0 | 1 | 0 | 1 | 0 | 1 | 1 | 1 |
| 11 | 1 | 1 | 1 | 0 | 1 | 0 | 0 | 0 | 1 | 1 | 1 |
| 12 | 1 | 0 | 0 | 1 | 1 | 0 | 0 | 1 | 1 | 0 | 1 |
| 13 | 1 | 1 | 0 | 1 | 1 | 0 | 0 | 1 | 0 | 1 | 1 |
| 14 | 1 | 0 | 1 | 1 | 1 | 0 | 1 | 0 | 0 | 1 | 1 |
| 15 | 1 | 1 | 1 | 1 | 1 | 0 | 1 | 1 | 1 | 1 | 0 |
| 16 | 1 | 0 | 0 | 0 | 0 | 1 | 1 | 0 | 0 | 0 | 0 |
| 17 | 1 | 1 | 0 | 0 | 0 | 1 | 1 | 1 | 0 | 0 | 1 |
| 18 | 1 | 0 | 1 | 0 | 0 | 1 | 1 | 1 | 0 | 1 | 1 |
| 19 | 1 | 1 | 1 | 0 | 0 | 1 | 1 | 0 | 1 | 0 | 1 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 20 | 1 | 0 | 0 | 1 | 0 | 1 | 0 | 1 | 1 | 1 | 1 |
| 21 | 1 | 1 | 0 | 1 | 0 | 1 | 0 | 1 | 0 | 1 | 1 |
| 22 | 1 | 0 | 1 | 1 | 0 | 1 | 0 | 0 | 1 | 1 | 0 |
| 23 | 1 | 1 | 1 | 1 | 0 | 1 | 0 | 1 | 1 | 1 | 0 |
| 24 | 1 | 0 | 0 | 0 | 1 | 1 | 0 | 1 | 0 | 0 | 1 |
| 25 | 1 | 1 | 0 | 0 | 1 | 1 | 1 | 1 | 0 | 1 | 1 |
| 26 | 1 | 0 | 1 | 0 | 1 | 1 | 1 | 0 | 1 | 0 | 0 |
| 27 | 1 | 1 | 1 | 0 | 1 | 1 | 1 | 0 | 0 | 1 | 0 |
| 28 | 1 | 0 | 0 | 1 | 1 | 1 | 0 | 0 | 1 | 0 | 0 |
| 29 | 1 | 1 | 0 | 1 | 1 | 1 | 1 | 1 | 0 | 0 | 0 |
| 30 | 1 | 0 | 1 | 1 | 1 | 1 | 1 | 1 | 1 | 0 | 0 |
| 31 | 1 | 1 | 1 | 1 | 1 | 1 | 1 | 1 | 1 | 1 | 1 |

For example, when the first encoding sequence is the encoding sequences shown in Table 14, the first interleaving pattern is shown in Table 15. The first interleaving pattern is a K nested puncturing sequence, where i in any table represents an $(i+1)^{th}$ position of the second codeword sequence, P(i) represents a bit that is in a $(P(i)+1)^{th}$ position of the first codeword sequence and that is placed in the $(i+1)^{th}$ position of the second codeword sequence, and $0 \leq i \leq 31$.

Table 15

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 31 | 4 | 28 | 8 | 26 | 12 | 9 | 16 | 22 | 20 | 15 | 24 | 0 | 28 | 10 |
| 1 | 21 | 5 | 25 | 9 | 29 | 13 | 11 | 17 | 4 | 21 | 27 | 25 | 14 | 29 | 24 |
| 2 | 8 | 6 | 7 | 10 | 18 | 14 | 18 | 18 | 30 | 22 | 12 | 26 | 19 | 30 | 23 |
| 3 | 6 | 7 | 3 | 11 | 20 | 15 | 17 | 19 | 5 | 23 | 2 | 27 | 1 | 31 | 13 |

When E is small, if the first codeword sequence is directly punctured from back to front for (32-E) times, a performance bad point may occur on an output sequence after rate matching. However, the to-be-encoded sequence is encoded based on Table 14 to obtain the first codeword sequence, and then the first codeword sequence is interleaved based on Table 15 to obtain the second codeword sequence. Then, the second codeword sequence is punctured from back to front for (32-E) times, so that it can be ensured that the output sequence (that is, the third codeword sequence) after rate matching has no performance bad point.

For example, when the first encoding sequence is the encoding sequences shown in Table 14, Table 16 to Table 24 respectively provide K non-nested puncturing sequences. Specifically, Table 16 is a puncturing sequence of a to-be-encoded sequence whose length is 3, and Table 17 is a puncturing sequence of a to-be-encoded sequence whose length is 4. The rest can be deduced by analogy. Table 23 is a puncturing sequence of a to-be-encoded sequence whose length is 10, and Table 24 is a puncturing sequence of a to-be-encoded sequence whose length is 11. i in any table represents an $(i+1)^{th}$ position of the second codeword sequence, P(i) represents a bit that is in a $(P(i)+1)^{th}$ position of the first codeword sequence and that is placed in the $(i+1)^{th}$ position of the second codeword sequence, and $0 \leq i \leq 31$.

Table 16

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 26 | 4 | 8 | 8 | 4 | 12 | 3 | 16 | 7 | 20 | 23 | 24 | 29 | 28 | 18 |
| 1 | 24 | 5 | 27 | 9 | 30 | 13 | 0 | 17 | 21 | 21 | 28 | 25 | 14 | 29 | 19 |
| 2 | 11 | 6 | 13 | 10 | 31 | 14 | 25 | 18 | 6 | 22 | 10 | 26 | 15 | 30 | 9 |

(continued)

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 3 | 17 | 7 | 22 | 11 | 5 | 15 | 2 | 19 | 20 | 23 | 16 | 27 | 1 | 31 | 12 |

Table 17

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 3 | 8 | 10 | 12 | 20 | 16 | 21 | 20 | 14 | 24 | 26 | 28 | 12 |
| 1 | 2 | 5 | 24 | 9 | 6 | 13 | 17 | 17 | 1 | 21 | 7 | 25 | 23 | 29 | 9 |
| 2 | 5 | 6 | 25 | 10 | 15 | 14 | 11 | 18 | 19 | 22 | 0 | 26 | 22 | 30 | 29 |
| 3 | 31 | 7 | 28 | 11 | 16 | 15 | 13 | 19 | 8 | 23 | 4 | 27 | 27 | 31 | 18 |

Table 18

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 28 | 4 | 31 | 8 | 6 | 12 | 27 | 16 | 17 | 20 | 15 | 24 | 5 | 28 | 25 |
| 1 | 1 | 5 | 7 | 9 | 21 | 13 | 18 | 17 | 10 | 21 | 23 | 25 | 16 | 29 | 12 |
| 2 | 13 | 6 | 9 | 10 | 19 | 14 | 30 | 18 | 11 | 22 | 14 | 26 | 22 | 30 | 20 |
| 3 | 24 | 7 | 26 | 11 | 4 | 15 | 0 | 19 | 3 | 23 | 29 | 27 | 8 | 31 | 2 |

Table 19

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 27 | 4 | 22 | 8 | 17 | 12 | 9 | 16 | 6 | 20 | 2 | 24 | 8 | 28 | 18 |
| 1 | 12 | 5 | 3 | 9 | 7 | 13 | 10 | 17 | 25 | 21 | 13 | 25 | 21 | 29 | 16 |
| 2 | 15 | 6 | 5 | 10 | 26 | 14 | 14 | 18 | 24 | 22 | 4 | 26 | 0 | 30 | 23 |
| 3 | 30 | 7 | 1 | 11 | 31 | 15 | 28 | 19 | 20 | 23 | 11 | 27 | 29 | 31 | 19 |

Table 20

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 8 | 4 | 28 | 8 | 3 | 12 | 12 | 16 | 16 | 20 | 30 | 24 | 2 | 28 | 26 |
| 1 | 5 | 5 | 1 | 9 | 13 | 13 | 20 | 17 | 0 | 21 | 10 | 25 | 27 | 29 | 19 |
| 2 | 14 | 6 | 15 | 10 | 18 | 14 | 11 | 18 | 24 | 22 | 17 | 26 | 21 | 30 | 9 |
| 3 | 22 | 7 | 6 | 11 | 29 | 15 | 4 | 19 | 25 | 23 | 23 | 27 | 31 | 31 | 7 |

Table 21

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 26 | 4 | 18 | 8 | 13 | 12 | 23 | 16 | 3 | 20 | 30 | 24 | 20 | 28 | 14 |
| 1 | 31 | 5 | 0 | 9 | 29 | 13 | 12 | 17 | 2 | 21 | 7 | 25 | 21 | 29 | 9 |
| 2 | 25 | 6 | 4 | 10 | 10 | 14 | 22 | 18 | 6 | 22 | 1 | 26 | 24 | 30 | 16 |
| 3 | 28 | 7 | 27 | 11 | 19 | 15 | 8 | 19 | 11 | 23 | 5 | 27 | 17 | 31 | 15 |

Table 22

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 1 | 4 | 27 | 8 | 31 | 12 | 6 | 16 | 23 | 20 | 2 | 24 | 29 | 28 | 14 |

(continued)

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 1 | 3 | 5 | 18 | 9 | 20 | 13 | 13 | 17 | 26 | 21 | 7 | 25 | 8 | 29 | 15 |
| 2 | 5 | 6 | 10 | 10 | 0 | 14 | 30 | 18 | 25 | 22 | 16 | 26 | 24 | 30 | 21 |
| 3 | 12 | 7 | 11 | 11 | 22 | 15 | 28 | 19 | 9 | 23 | 19 | 27 | 4 | 31 | 17 |

Table 23

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 27 | 4 | 18 | 8 | 13 | 12 | 11 | 16 | 12 | 20 | 5 | 24 | 30 | 28 | 26 |
| 1 | 6 | 5 | 2 | 9 | 7 | 13 | 1 | 17 | 16 | 21 | 10 | 25 | 24 | 29 | 14 |
| 2 | 19 | 6 | 8 | 10 | 3 | 25 | 21 | 18 | 4 | 22 | 31 | 26 | 23 | 30 | 29 |
| 3 | 17 | 7 | 15 | 11 | 22 | 15 | 9 | 19 | 20 | 23 | 0 | 27 | 9 | 31 | 28 |

Table 24

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 5 | 4 | 29 | 8 | 16 | 12 | 12 | 16 | 18 | 20 | 15 | 24 | 11 | 28 | 9 |
| 1 | 25 | 5 | 2 | 9 | 7 | 13 | 20 | 17 | 27 | 21 | 0 | 25 | 14 | 29 | 28 |
| 2 | 10 | 6 | 31 | 10 | 8 | 14 | 17 | 18 | 24 | 22 | 13 | 26 | 6 | 30 | 19 |
| 3 | 23 | 7 | 30 | 11 | 1 | 15 | 21 | 19 | 26 | 23 | 3 | 27 | 4 | 31 | 22 |

Similarly, Table 16 to Table 24 may be E nested puncturing sequences when K is not nested. Table 24 corresponding to K=11 is used as an example. The E nested puncturing sequence is a same puncturing sequence used when $12 \leq E \leq 31$. It can be learned from the foregoing descriptions that, when the length of the to-be-encoded sequence is K, a smallest value of a length E of the third codeword sequence after rate matching is K+1. In other words, when E=K+1, a quantity (32-K-1) of to-be-punctured bits is a largest quantity of to-be-punctured bits. If a codeword sequence obtained by encoding the to-be-encoded sequence based on the encoding sequences shown in Table 1 is punctured from back to front for (32-E) times, a performance bad point occurs on an output sequence after rate matching. In this application, the first codeword sequence is obtained by encoding the to-be-encoded sequence based on Table 14, the first codeword sequence is interleaved based on a table corresponding to the length K of the to-be-encoded sequence in Table 16 to Table 24, to obtain the second codeword sequence, and the second codeword sequence is punctured from back to front for (32-E) times, so that it can be ensured that the output sequence (that is, the third codeword sequence) after rate matching has no performance bad point.

For example, K=11. A smallest value of E is 12, and a largest quantity of to-be-punctured bits is 20. In this case, when 12<E<32, a quantity of to-be-punctured bits when rate matching is performed is less than 20. Therefore, puncturing may also be performed based on Table 24. Alternatively, because quantities of bits that need to be punctured when rate matching is performed are different based on different values of E, an interleaving pattern corresponding to each value of E may be provided based on Table 12, and puncturing is performed based on the provided interleaving pattern. For example, when E is not nested, E=18 is used as an example. A quantity of to-be-punctured bits is 14. For example, a corresponding first interleaving pattern is shown in Table 25. Other examples are not described herein again.

Table 25

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | / | 4 | / | 8 | / | 12 | / | 16 | / | 20 | 15 | 24 | 11 | 28 | 9 |
| 1 | / | 5 | / | 9 | / | 13 | / | 17 | / | 21 | 0 | 25 | 14 | 29 | 28 |
| 2 | / | 6 | / | 10 | / | 14 | / | 18 | 24 | 22 | 13 | 26 | 6 | 30 | 19 |
| 3 | / | 7 | / | 11 | / | 15 | / | 19 | 26 | 23 | 3 | 27 | 4 | 31 | 22 |

Specifically, when K=11 and E=14, Table 25 provides bits that are in positions 25, 27, 16, ..., 29, 20, and 23 in the first codeword sequence and that are respectively placed in 14 positions for which i is equal to 18 to 31 in the second codeword sequence. In addition, bits in remaining 18 positions in the first codeword sequence may be placed in 18 positions for which i is equal to 0 to 17 in the second codeword sequence in one-to-one correspondence, and a placement order of the bits in the remaining 18 positions is not limited in this application. Although the order of the remaining 18 positions is not limited, specific values of P(i) corresponding to i=0 to 17 still need to be provided in an actual application of Table 25. "/" herein represents that an order is not limited, and does not indicate that P(i) corresponding to i=0 to 17 does not exist.

It should be noted that, the K nested interleaving pattern (Table 2 or Table 3) or the K non-nested interleaving pattern (Table 4 to Table 12) corresponding to Table 1 is merely an example. Although these interleaving patterns ensure that the output sequence after rate matching has no performance bad point, there are 32! possible interleaving patterns. If the interleaving patterns are found by using an enumeration method, complexity is extremely high. Therefore, this application provides a search algorithm for determining an interleaving pattern, to reduce the complexity of finding the interleaving patterns. The following describes the search algorithm in different cases based on cases in which a K non-nested interleaving pattern is determined and a K nested interleaving pattern is determined.

1. A K nested puncturing sequence is determined based on the search algorithm provided in this application. That is, a same first interleaving pattern corresponding to to-be-encoded sequences of different lengths is determined. Herein, a to-be-encoded sequence whose length is K1 and a to-be-encoded sequence whose length is K2 are used as an example for description, where K1 is the length of the to-be-encoded sequence, and K1 and K2 are not equal. For example, $3 \leq K1 \leq 11$, and $3 \leq K2 \leq 11$.

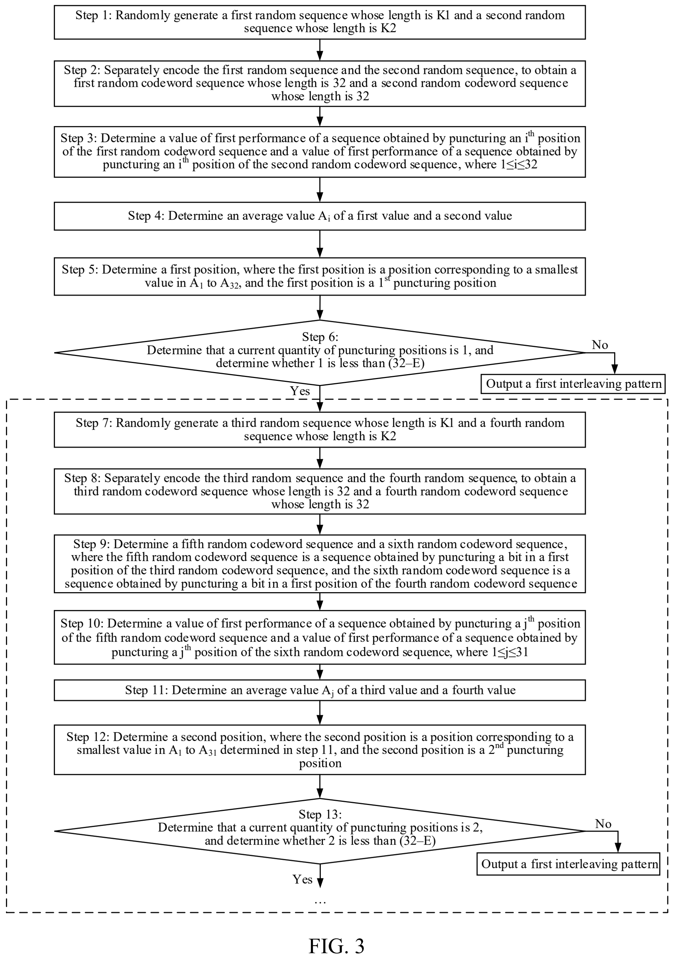

FIG. 3 is a diagram of a search algorithm for determining a K nested puncturing sequence according to this application. The method includes step 1 to step 20. Step 7 to step 20 are optional steps when a determining result in step 6 is "no". FIG. 3 merely shows step 1 to step 13 as an example.

Step 1: Randomly generate a first random sequence whose length is K1 and a second random sequence whose length is K2.

Step 2: Separately encode the first random sequence and the second random sequence based on the encoding sequences shown in Table 1, to obtain a first random codeword sequence whose length is 32 and a second random codeword sequence whose length is 32.

Step 3: Determine a value of first performance of a sequence obtained by puncturing an $i^{th}$ position of the first random codeword sequence and a value of first performance of a sequence obtained by puncturing an $i^{th}$ position of the second random codeword sequence, where $1 \leq i \leq 32$.

Step 4: Determine an average value $A_i$ of a first value and a second value, where the first value is the value of the first performance of the sequence obtained by puncturing the $i^{th}$ position of the first random codeword sequence, and the second value is the value of the first performance of the sequence obtained by puncturing the $i^{th}$ position of the second random codeword sequence.

Specifically, the value of the first performance is a value that is of an SNR and that corresponds to a BLER being equal to 0.01, and a smaller value of first performance indicates better first performance.

Step 5: Determine a first position, where the first position is a position corresponding to a smallest value in $A_1$ to $A_{32}$, and the first position is a $1^{st}$ puncturing position.

Step 6: Determine that a current quantity of puncturing positions is 1, and determine whether 1 is less than (32-E).

If the quantity 1 of to-be-punctured bits is equal to (32-E), a procedure ends, and a first interleaving pattern (that is, an optimal interleaving pattern) is output. The first interleaving pattern indicates that after a first sequence is interleaved based on the first interleaving pattern, a bit in the first position of the first sequence is placed in a last bit position of the first sequence for adjustment. The first sequence is a sequence whose length is 32.

If the quantity 1 of to-be-punctured bits is less than (32-E), step 7 to step 13 are performed.

Step 7: Randomly generate a third random sequence whose length is K1 and a fourth random sequence whose length is K2.

Step 8: Separately encode the third random sequence and the fourth random sequence based on the encoding sequences shown in Table 1, to obtain a third random codeword sequence whose length is 32 and a fourth random codeword sequence whose length is 32.

Step 9: Determine a fifth random codeword sequence and a sixth random codeword sequence, where the fifth random codeword sequence is a sequence obtained by puncturing a bit in a first position of the third random codeword sequence, and the sixth random codeword sequence is a sequence obtained by puncturing a bit in a first position of the fourth random codeword sequence.

Step 10: Determine a value of first performance of a sequence obtained by puncturing a $j^{th}$ position of the fifth random codeword sequence and a value of first performance of a sequence obtained by puncturing a $j^{th}$ position of the sixth random codeword sequence, where $1 \leq j \leq 31$.

Step 11: Determine an average value $A_j$ of a third value and a fourth value, where the third value is the value of the first performance of the sequence obtained by puncturing the $j^{th}$ position of the fifth random codeword sequence, and the fourth value is the value of the first performance of the sequence obtained by puncturing the $j^{th}$ position of the sixth random codeword sequence.

Step 12: Determine a second position, where the second position is a position corresponding to a smallest value in $A_1$ to $A_{31}$ determined in step 11, and the second position is a $2^{nd}$ puncturing position.

Step 13: Determine that a current quantity of puncturing positions is 2, and determine whether 2 is less than (32-E).

If the quantity 2 of to-be-punctured bits is equal to (32-E), a procedure ends, and a first interleaving pattern is generated. The first interleaving pattern indicates that after a first sequence is interleaved based on the first interleaving pattern, a bit in the first position of the first sequence is placed in a last bit position of the first sequence for adjustment, and a bit in the second position of the first sequence is placed in a penultimate bit position of the first sequence for adjustment.

If the quantity 2 of to-be-punctured bits is less than (32-E), step 14 to step 20 are performed.

Step 14: Randomly generate a fifth random sequence whose length is K1 and a sixth random sequence whose length is K2.

Step 15: Separately encode the fifth random sequence and the sixth random sequence based on the encoding sequences shown in Table 1, to obtain a seventh random codeword sequence whose length is 32 and an eighth random codeword sequence whose length is 32.

Step 16: Determine a ninth random codeword sequence and a tenth random codeword sequence, where the ninth random codeword sequence is a sequence obtained by puncturing a bit in a first position of the seventh random codeword sequence, and the tenth random codeword sequence is a sequence obtained by puncturing a bit in a first position of the eighth random codeword sequence.

Step 17: Determine a value of first performance of a sequence obtained by puncturing an $s^{th}$ position of the ninth random codeword sequence and a value of first performance of a sequence obtained by puncturing an $s^{th}$ position of the tenth random codeword sequence, where $1 \leq s \leq 30$.

Step 18: Determine an average value $A_s$ of a fifth value and a sixth value, where the fifth value is the value of the first performance of the sequence obtained by puncturing the $s^{th}$ position of the ninth random codeword sequence, and the sixth value is the value of the first performance of the sequence obtained by puncturing the $s^{th}$ position of the tenth random codeword sequence.

Step 19: Determine a third position, where the third position is a position corresponding to a smallest value in $A_1$ to $A_{30}$ determined in step 18, and the second position is a $2^{nd}$ puncturing position.

Step 20: Determine that a current quantity of puncturing positions is 3, and determine whether 3 is less than (32-E).

If the quantity 3 of to-be-punctured bits is equal to (32-E), a procedure ends, and a first interleaving pattern is generated. The first interleaving pattern indicates that after a first sequence is interleaved based on the first interleaving pattern, a bit in the first position of the first sequence is placed in a last bit position of the first sequence for adjustment, a bit in the second position of the first sequence is placed in a penultimate bit position of the first sequence for adjustment, and a bit in the third position of the first sequence is placed in a third to last bit position of the first sequence for adjustment.

If the quantity 3 of to-be-punctured bits is less than (32-E), the foregoing operations are repeatedly performed until the quantity of to-be-punctured bits is equal to (32-E), to obtain a corresponding optimal first interleaving pattern. Details are not described herein again.

It may be understood that, because the position corresponding to the smallest value of the average value of the values of the first performance is selected in steps 5, 12, and 19, it may be considered that the first interleaving pattern obtained when the procedure ends is the optimal interleaving pattern.

For example, in steps 5, 12, and 19, a puncturing position corresponding to a penultimate smallest value or a third-to-last smallest value may also be selected as a puncturing position determined in a corresponding step. This is not limited in this application.

It should be noted that, in the foregoing procedure, to-be-encoded sequences corresponding to two K values are used as an example to describe a puncturing sequence search procedure, and a K1 nested puncturing sequence and a K2 nested puncturing sequence are obtained. Correspondingly, if nested puncturing sequences corresponding to K=3 to 11 need to be obtained, nine corresponding random sequences need to be randomly generated in step 1 when K=3 to 11. In step 2, all the random sequences are encoded based on the encoding sequences shown in Table 1 to generate nine random codeword sequences. In step 3, values of first performance of sequences obtained by puncturing $i^{th}$ positions of all the random codeword sequences are determined. In step 4, an average value of the values of the first performance of the sequences obtained by puncturing the $i^{th}$ positions of the nine random codeword sequences is determined. In step 5, a determined first position is a smallest value of an average value of values of first performance corresponding to the nine random codeword sequences obtained by puncturing $1^{st}$ positions to $32^{nd}$ positions. Details are not described in subsequent steps.

For example, Table 26 provides an optimal K nested puncturing sequence obtained based on the foregoing search algorithm. Each of rows corresponding to different values of K in Table 26 may be another representation form of

Table 2.

Table 26

| E\K | 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 |
|---|---|---|---|---|---|---|---|---|---|---|---|---|---|---|---|---|---|---|---|---|---|---|---|---|---|---|---|---|
| 3 | 8 | 27 | 14 | 6 | 0 | 11 | 9 | 31 | 20 | 7 | 16 | 24 | 21 | 29 | 2 | 26 | 25 | 10 | 23 | 5 | 12 | 19 | 18 | 28 | 1 | 4 | 15 | 17 |
| 4 | 8 | 27 | 14 | 6 | 0 | 11 | 9 | 31 | 20 | 7 | 16 | 24 | 21 | 29 | 2 | 26 | 25 | 10 | 23 | 5 | 12 | 19 | 18 | 28 | 1 | 4 | 15 | |
| 5 | 8 | 27 | 14 | 6 | 0 | 11 | 9 | 31 | 20 | 7 | 16 | 24 | 21 | 29 | 2 | 26 | 25 | 10 | 23 | 5 | 12 | 19 | 18 | 28 | 1 | 4 | | |
| 6 | 8 | 27 | 14 | 6 | 0 | 11 | 9 | 31 | 20 | 7 | 16 | 24 | 21 | 29 | 2 | 26 | 25 | 10 | 23 | 5 | 12 | 19 | 18 | 28 | 1 | | | |
| 7 | 8 | 27 | 14 | 6 | 0 | 11 | 9 | 31 | 20 | 7 | 16 | 24 | 21 | 29 | 2 | 26 | 25 | 10 | 23 | 5 | 12 | 19 | 18 | 28 | | | | |
| 8 | 8 | 27 | 14 | 6 | 0 | 11 | 9 | 31 | 20 | 7 | 16 | 24 | 21 | 29 | 2 | 26 | 25 | 10 | 23 | 5 | 12 | 19 | 18 | | | | | |
| 9 | 8 | 27 | 14 | 6 | 0 | 11 | 9 | 31 | 20 | 7 | 16 | 24 | 21 | 29 | 2 | 26 | 25 | 10 | 23 | 5 | 12 | 19 | | | | | | |
| 10 | 8 | 27 | 14 | 6 | 0 | 11 | 9 | 31 | 20 | 7 | 16 | 24 | 21 | 29 | 2 | 26 | 25 | 10 | 23 | 5 | 12 | | | | | | | |
| 11 | 8 | 27 | 14 | 6 | 0 | 11 | 9 | 31 | 20 | 7 | 16 | 24 | 21 | 29 | 2 | 26 | 25 | 10 | 23 | 5 | | | | | | | | |

In Table 26, it may be considered that all sequences whose lengths are K share one set of puncturing sequences, a smallest value of a length E of a sequence whose length is K after puncturing is (K+1), and a largest value of the length E is (N-1). An element in Table 26 represents a puncturing position. It may be understood that, when K=3, a smallest length after puncturing is E=K+1=4, and a largest quantity of to-be-punctured bits of any sequence whose length is K does not exceed (32-E)=28. Therefore, based on the foregoing search algorithm, only 28 puncturing positions corresponding to E=31 to 4 when K=3 in Table 26 need to be determined, positions corresponding to E=4 to 0 are not punctured, and remaining four bit positions are randomly arranged. This is not specifically limited in this application. For example, in the embodiment shown in FIG. 2, when K=11 and E=14, interleaving needs to be performed on the first codeword sequence whose length is 32 based on Table 26, to obtain the second codeword sequence, and then puncturing is sequentially performed from back to front for 18 times. To be specific, bits in positions {8,27,14,6,0,11,9,31,20,7,16,24,21,29,2,26,25,10} of the first codeword sequence are punctured. For another example, when K=7 and E=22, interleaving needs to be performed on the first codeword sequence whose length is 32 based on Table 26, to obtain the second codeword sequence, and then puncturing is sequentially performed from back to front for 10 times. To be specific, bits in positions {8,27,14,6,0,11,9,31,20,7} of the first codeword sequence are punctured. It should be understood that the 8th position herein is obtained by numbering positions starting from a 1st position as a position 0. If the 1st position is a position 1, the 8th position is a 9th position. This is similar for an order of other positions, and examples are not described herein again.

For example, if E is less than 20, that is, a quantity (32-E) of to-be-punctured bits is greater than 12, the interleaving pattern in Table 3 needs to be obtained based on the search algorithm provided in this application. It may be considered that 12 positions determined by performing 12 rounds of search based on the search algorithm are sequentially 12 positions from back to front in the first codeword sequence. When a 13th round of search is performed, a 13th puncturing position is determined according to the foregoing procedure, and whether 13 is less than (32-E) is determined. If the quantity 13 of to-be-punctured bits is equal to (32-E), a procedure ends, and a first interleaving pattern is generated. If the quantity 13 of to-be-punctured bits is less than (32-E), a search operation is repeatedly performed until the quantity of to-be-punctured bits is equal to E, to obtain a corresponding first interleaving pattern. Details are not described herein again.

2. Based on the search algorithm provided in this application, a K non-nested puncturing sequence is determined. That is, first interleaving patterns respectively corresponding to to-be-encoded sequences of different lengths are determined.

Step 1: Randomly generate a first random sequence whose length is K. For example, 3≤K≤11.

Step 2: Encode the first random sequence based on the encoding sequences shown in Table 1, to obtain a first random codeword sequence whose length is 32.

Step 3: Determine a value $B_i$ of first performance of a sequence obtained by puncturing an $i$th position of the first random codeword sequence, where $1 \le i \le 32$.

For example, in this application, the value of the first performance is a value that is of an SNR and that corresponds to a BLER being equal to 0.01.

Step 4: Determine a first position, where the first position is a position corresponding to a smallest value in $B_1$ to $B_{32}$, and the first position is a determined first puncturing position.

Step 5: Determine that a current quantity of puncturing positions is 1, and determine whether 1 is less than (32-E).

If the quantity 1 of to-be-punctured bits is equal to (32-E), a procedure ends, and a first interleaving pattern (that is, an optimal interleaving pattern) is generated. The first interleaving pattern indicates that after a first sequence is interleaved based on the first interleaving pattern, a bit in the first position of the first sequence is placed in a last bit position of the first sequence for adjustment. The first sequence is a sequence whose length is 32.

If the quantity 1 of to-be-punctured bits is less than (32-E), step 6 to step 11 are performed.

Step 6: Randomly generate a second random sequence whose length is K.

Step 7: Encode the second random sequence based on the encoding sequences shown in Table 1, to obtain a second random codeword sequence whose length is 32.

Step 8: Determine a third random codeword sequence, where the third random codeword sequence is a sequence obtained by puncturing a bit in a first position of the second random codeword sequence.

Step 9: Determine a value $B_j$ of first performance of a sequence obtained by puncturing a $j^{th}$ position of the third random codeword sequence, where $1 \le j \le 31$.

Step 10: Determine a second position, where the second position is a position corresponding to a smallest value in $B_1$ to $B_{31}$ determined in step 9, and the second position is a $2^{nd}$ puncturing position.

Step 11: Determine that a current quantity of puncturing positions is 2, and determine whether 2 is less than (32-E).

If the quantity 2 of to-be-punctured bits is equal to (32-E), a procedure ends, and a first interleaving pattern is generated. The first interleaving pattern indicates that after a first sequence is interleaved based on the first interleaving pattern, a bit in the first position of the first sequence is placed in a last bit position of the first sequence for adjustment, and a bit in the second position of the first sequence is placed in a penultimate bit position of the first sequence for adjustment.

If the quantity 2 of to-be-punctured bits is less than (32-E), step 12 to step 17 are performed.

Step 12: Randomly generate a third random sequence whose length is K.

Step 13: Encode the third random sequence based on the encoding sequences shown in Table 1, to obtain a fourth random codeword sequence whose length is 32.

Step 14: Determine a fifth random codeword sequence, where the fifth random codeword sequence is a sequence obtained by puncturing a bit in a first position and a bit in a second position of the fourth random codeword sequence.

Step 15: Determine a value $B_s$ of first performance of a sequence obtained by puncturing an $s^{th}$ position of the fifth random codeword sequence, where $1 \le s \le 30$.

Step 16: Determine a third position, where the third position is a position corresponding to a smallest value in $B_1$ to $B_{30}$ determined in step 15, and the third position is a $3^{rd}$ puncturing position.

Step 17: Determine that a current quantity of puncturing positions is 3, and determine whether 3 is less than (32-E).

If the quantity 3 of to-be-punctured bits is equal to (32-E), a procedure ends, and a first interleaving pattern is generated. The first interleaving pattern indicates that after a first sequence is interleaved based on the first interleaving pattern, a bit in the first position of the first sequence is placed in a last bit position of the first sequence for adjustment, a bit in the second position of the first sequence is placed in a penultimate bit position of the first sequence for adjustment, and a bit in the third position of the first sequence is placed in a third to last bit position of the first sequence for adjustment.

If the quantity 3 of to-be-punctured bits is less than (32-E), the foregoing operations are repeatedly performed until the quantity of to-be-punctured bits is equal to (32-E), to obtain a corresponding first interleaving pattern. Details are not described herein again.

It may be understood that, because the position corresponding to the smallest value in the values of the first performance is selected in steps 4, 10, and 16, it may be considered that the first interleaving pattern obtained when the procedure ends is the optimal interleaving pattern.

For example, in steps 4, 10, and 16, a puncturing position corresponding to a penultimate smallest value or a third-to-last smallest value may also be selected as a puncturing position determined in a corresponding step. This is not limited in this application.

For example, Table 27 provides optimal puncturing sequences corresponding to different values of K when K is not nested. In other words, puncturing sequences are respectively designed based on different values of K in the table. It may be understood that each of rows corresponding to different values of K in Table 27 may be another representation form of Table 4 to Table 19.

Table 27

| E\K | 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 |
|---|---|---|---|---|---|---|---|---|---|---|---|---|---|---|---|---|---|---|---|---|---|---|---|---|---|---|---|---|
| 3 | 7 | 5 | 11 | 10 | 0 | 24 | 8 | 18 | 19 | 6 | 17 | 27 | 12 | 3 | 13 | 4 | 20 | 15 | 31 | 1 | 21 | 30 | 29 | 2 | 26 | 8 | 16 | 22 |
| 4 | 10 | 18 | 5 | 7 | 16 | 26 | 27 | 28 | 2 | 31 | 4 | 9 | 22 | 11 | 0 | 13 | 8 | 23 | 25 | 12 | 19 | 24 | 3 | 6 | 17 | 15 | 14 | |
| 5 | 20 | 12 | 7 | 15 | 22 | 26 | 19 | 21 | 18 | 9 | 27 | 24 | 1 | 23 | 6 | 25 | 31 | 29 | 10 | 16 | 2 | 11 | 13 | 3 | 28 | 5 | | |
| 6 | 11 | 27 | 19 | 10 | 18 | 31 | 13 | 22 | 23 | 2 | 8 | 20 | 12 | 14 | 15 | 3 | 17 | 9 | 6 | 5 | 30 | 28 | 4 | 25 | 0 | | | |
| 7 | 4 | 5 | 11 | 28 | 30 | 13 | 16 | 20 | 27 | 25 | 6 | 29 | 15 | 14 | 31 | 19 | 2 | 23 | 12 | 7 | 18 | 10 | 8 | 1 | | | | |
| 8 | 24 | 19 | 5 | 9 | 25 | 14 | 13 | 12 | 21 | 0 | 4 | 29 | 23 | 3 | 20 | 1 | 22 | 26 | 7 | 27 | 11 | 6 | 18 | | | | | |
| 9 | 25 | 13 | 24 | 9 | 2 | 14 | 22 | 18 | 11 | 19 | 4 | 20 | 5 | 15 | 28 | 27 | 17 | 29 | 8 | 3 | 26 | 31 | | | | | | |
| 10 | 17 | 18 | 9 | 28 | 22 | 27 | 14 | 29 | 31 | 30 | 6 | 21 | 12 | 2 | 19 | 7 | 5 | 13 | 0 | 23 | 26 | | | | | | | |
| 11 | 26 | 11 | 17 | 5 | 2 | 3 | 9 | 23 | 1 | 8 | 31 | 24 | 28 | 14 | 16 | 10 | 13 | 25 | 12 | 7 | | | | | | | | |

For each value of K, a smallest value of the length E after puncturing is (K+1), and a largest value of the length E is (N-1). An element in Table 27 represents a puncturing position. For example, K=11 is used as an example. The smallest length after puncturing may be E=K+1=12, and a largest quantity of to-be-punctured bits is (32-E)=20. Therefore, based on the foregoing search algorithm, only 20 puncturing positions corresponding to E=31 to 12 in Table 27 need to be determined, positions corresponding to E=11 to 0 are not punctured, and remaining 12 bit positions are randomly arranged. This is not specifically limited in this application. It should be noted that, when K=11, because the smallest value of the length E after puncturing may be K+1=12, and the largest value of the length E may be N-1=31. When E is greater than 12 and less than 31, because the quantity of to-be-punctured bits is less than 20, the first device may determine, based on the interleaving pattern corresponding to K=11 in Table 27, specific positions in which puncturing is to be performed. For example, when K=11 and E=14, interleaving needs to be performed on the first codeword sequence whose length is 32 based on Table 27, to obtain the second codeword sequence, and then puncturing is sequentially performed from back to front for 18 times. To be specific, bits in positions {26,11,17,5,2,3,9,23,1,8,31,24,28,14,16,10,13,25} of the first codeword sequence are punctured. For another example, when K=7 and E=22, interleaving needs to be performed on the first codeword sequence whose length is 32 based on Table 29, to obtain the second codeword sequence, and then puncturing is sequentially performed from back to front for 18 times. To be specific, bits in positions {4,5,11,28,30,13,16,20,27,25} of the first codeword sequence are punctured.

Similarly, the K nested interleaving pattern (Table 15) or the K non-nested interleaving pattern (Table 16 to Table 24) corresponding to Table 14 is merely an example. Although these interleaving patterns ensure that the output sequence after rate matching has no performance bad point, there are 32! possible interleaving patterns. If the interleaving patterns are found by using an enumeration method, complexity is extremely high. Therefore, this application provides a search algorithm for determining an interleaving pattern, to find an interleaving pattern with optimal performance. The following describes the search algorithm in different cases based on cases in which a K non-nested interleaving pattern is determined and a K nested interleaving pattern is determined.

1. The K nested puncturing sequence is determined based on the search algorithm provided in this application. That is, a same optimal first interleaving pattern corresponding to to-be-encoded sequences of different lengths is determined. Herein, a to-be-encoded sequence whose length is K1 and a to-be-encoded sequence whose length is K2 are used as an example for description, where K1 is the length of the to-be-encoded sequence, and K1 and K2 are not equal. For example, $3 \leq K1 \leq 11$, and $3 \leq K2 \leq 11$.

The search algorithm is basically similar to the search procedure in which the K nested puncturing sequence is determined based on Table 1. A difference between the two is mainly described herein. Specifically, the difference lies in that step 2 needs to be modified as follows: Separately encode the first random sequence and the second random sequence based on the encoding sequences shown in Table 14, to obtain the first random codeword sequence and the second random codeword sequence. Because encoding is performed based on Table 14 in step 2, in step 3, the first random codeword sequence and the second random codeword sequence further need to be decoded based on Table 14, and then the value of the first performance of the sequence obtained by puncturing the $i^{th}$ position is calculated. Similarly, the same modification is made in step 8 and step 15 with reference to step 2, and the same modification is made in step 9 and step 16 with reference to step 3. A specific procedure is not described herein again.

For example, Table 28 provides the K nested puncturing sequence obtained based on the encoding matrix shown in Table 14. It may be understood that each of rows corresponding to different values of K in Table 28 may be another representation form of Table 15.

Table 28

| E / K | 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 |
|---|---|---|---|---|---|---|---|---|---|---|---|---|---|---|---|---|---|---|---|---|---|---|---|---|---|---|---|---|
| 3 | 13 | 23 | 24 | 10 | 1 | 19 | 14 | 0 | 2 | 12 | 27 | 15 | 5 | 30 | 4 | 22 | 17 | 18 | 11 | 9 | 20 | 16 | 29 | 28 | 3 | 7 | 25 | 8 |
| 4 | 13 | 23 | 24 | 10 | 1 | 19 | 14 | 0 | 2 | 12 | 27 | 15 | 5 | 30 | 4 | 22 | 17 | 18 | 11 | 9 | 20 | 16 | 29 | 28 | 3 | 7 | 25 | |
| 5 | 13 | 23 | 24 | 10 | 1 | 19 | 14 | 0 | 2 | 12 | 27 | 15 | 5 | 30 | 4 | 22 | 17 | 18 | 11 | 9 | 20 | 16 | 29 | 28 | 3 | 7 | | |
| 6 | 13 | 23 | 24 | 10 | 1 | 19 | 14 | 0 | 2 | 12 | 27 | 15 | 5 | 30 | 4 | 22 | 17 | 18 | 11 | 9 | 20 | 16 | 29 | 28 | 3 | | | |

| E / K | 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 |
|---|---|---|---|---|---|---|---|---|---|---|---|---|---|---|---|---|---|---|---|---|---|---|---|---|---|---|---|---|
| 7 | 13 | 23 | 24 | 10 | 1 | 19 | 14 | 0 | 2 | 12 | 27 | 15 | 5 | 30 | 4 | 22 | 17 | 18 | 11 | 9 | 20 | 16 | 29 | 28 | | | | |
| 8 | 13 | 23 | 24 | 10 | 1 | 19 | 14 | 0 | 2 | 12 | 27 | 15 | 5 | 30 | 4 | 22 | 17 | 18 | 11 | 9 | 20 | 16 | 29 | | | | | |
| 9 | 13 | 23 | 24 | 10 | 1 | 19 | 14 | 0 | 2 | 12 | 27 | 15 | 5 | 30 | 4 | 22 | 17 | 18 | 11 | 9 | 20 | 16 | | | | | | |
| 10 | 13 | 23 | 24 | 10 | 1 | 19 | 14 | 0 | 2 | 12 | 27 | 15 | 5 | 30 | 4 | 22 | 17 | 18 | 11 | 9 | 20 | | | | | | | |
| 11 | 13 | 23 | 24 | 10 | 1 | 19 | 14 | 0 | 2 | 12 | 27 | 15 | 5 | 30 | 4 | 22 | 17 | 18 | 11 | 9 | | | | | | | | |

All sequences whose lengths are K share one set of puncturing sequences, a smallest value of the length E of a sequence whose length is K after puncturing is (K+1), and a largest value of the length E is (N-1). An element in Table 28 represents a puncturing position. It may be understood that, when K=3, a smallest length after puncturing is E=K+1=4, and a largest quantity of to-be-punctured bits of any sequence whose length is K does not exceed (32-E)=28. Therefore, based on the foregoing search algorithm, only 28 puncturing positions corresponding to E=31 to 4 when K=3 in Table 28 need to be determined, positions corresponding to E=4 to 0 are not punctured, and remaining four bit positions are randomly arranged. This is not specifically limited in this application. For example, in the embodiment shown in FIG. 2, when K=11 and E=14, interleaving needs to be performed on the first codeword sequence whose length is 32 based on Table 26, to obtain the second codeword sequence, and then puncturing is sequentially performed from back to front for 18 times. To be specific, bits in positions {13,23,24,10,1,19,14,0,2,12,27,15,5,30,4,22,17,18} of the first codeword sequence are punctured. For another example, when K=7 and E=22, the second codeword sequence whose length is 32 needs to be punctured based on the positions provided in Table 28. To be specific, bits in positions {13,23,24,10,1,19,14,0,2,12} of the first codeword sequence are punctured.

2. Based on the search algorithm provided in this application, a K non-nested puncturing sequence is determined. That is, optimal first interleaving patterns respectively corresponding to to-be-encoded sequences of different lengths are determined.

The search algorithm is basically similar to the search procedure in which the K non-nested puncturing sequence is determined based on Table 1. A difference between the two are mainly described herein. Specifically, the difference lies in that step 2 needs to be modified as follows: Encode the first random sequence based on the encoding sequences shown in Table 14, to obtain the first random codeword sequence. Because encoding is performed based on Table 14 in step 2, in step 3, the first random codeword sequence and the second random codeword sequence further need to be decoded based on Table 14, and then the value of the first performance of the sequence obtained by puncturing the $i^{th}$ position is calculated. The same modification is made in step 7 and step 13 with reference to step 2, and the same modification is made in step 8 and step 14 with reference to step 3. A specific procedure is not described herein again.

For example, Table 29 provides optimal E nested puncturing sequences corresponding to different values of K when K is not nested. In other words, puncturing sequences are respectively designed based on different values of K in the table. It may be understood that each row in Table 29 may be another representation form of Table 16 to Table 24.

Table 29

| E\K | 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 |
|---|---|---|---|---|---|---|---|---|---|---|---|---|---|---|---|---|---|---|---|---|---|---|---|---|---|---|---|---|
| 3 | 12 | 9 | 19 | 18 | 1 | 17 | 14 | 29 | 16 | 10 | 28 | 23 | 20 | 6 | 21 | 7 | 2 | 25 | 0 | 3 | 5 | 31 | 30 | 4 | 22 | 13 | 27 | 9 |
| 4 | 18 | 29 | 9 | 12 | 27 | 22 | 23 | 26 | 4 | 0 | 7 | 14 | 8 | 19 | 1 | 21 | 13 | 11 | 17 | 20 | 16 | 15 | 6 | 10 | 28 | 25 | 24 | |
| 5 | 2 | 20 | 12 | 25 | 8 | 22 | 16 | 5 | 29 | 14 | 23 | 15 | 3 | 11 | 10 | 17 | 0 | 30 | 18 | 27 | 4 | 19 | 21 | 6 | 26 | 9 | | |
| 6 | 19 | 23 | 16 | 18 | 29 | 0 | 21 | 8 | 11 | 4 | 13 | 2 | 20 | 24 | 25 | 6 | 28 | 14 | 10 | 9 | 31 | 26 | 7 | 17 | 1 | | | |
| 7 | 7 | 9 | 19 | 26 | 31 | 21 | 27 | 2 | 22 | 17 | 10 | 30 | 25 | 24 | 0 | 16 | 4 | 11 | 20 | 12 | 29 | 18 | 13 | 3 | | | | |
| 8 | 15 | 16 | 9 | 14 | 17 | 24 | 21 | 20 | 5 | 1 | 7 | 30 | 11 | 6 | 2 | 3 | 8 | 22 | 12 | 23 | 19 | 10 | 29 | | | | | |
| 9 | 17 | 21 | 15 | 14 | 4 | 24 | 8 | 29 | 19 | 16 | 7 | 2 | 9 | 25 | 26 | 23 | 28 | 30 | 13 | 6 | 22 | 0 | | | | | | |
| 10 | 28 | 29 | 14 | 26 | 8 | 23 | 24 | 30 | 0 | 31 | 10 | 5 | 20 | 4 | 16 | 12 | 9 | 21 | 1 | 11 | 22 | | | | | | | |
| 11 | 22 | 19 | 28 | 9 | 4 | 6 | 14 | 11 | 3 | 13 | 0 | 15 | 26 | 24 | 27 | 18 | 21 | 19 | 20 | 12 | | | | | | | | |

For each value of K, a smallest value of the length E after puncturing is (K+1), and a largest value of the length E is (N-1). An element in Table 29 represents a puncturing position. For example, K=11 is used as an example. The smallest length after puncturing may be E=K+1=12, and a largest quantity of to-be-punctured bits is (32-E)=20. Therefore, based on the foregoing search algorithm, only 20 puncturing positions corresponding to E=31 to 12 in Table 29 need to be determined, positions corresponding to E=11 to 0 are not punctured, and remaining 12 bit positions are randomly arranged. This is not specifically limited in this application. It should be noted that, when K=11, because the smallest value of the length E after puncturing may be K+1=12, and the largest value of the length E may be N-1=31. When E is greater than 12 and less than 31, because the quantity of to-be-punctured bits is less than 20, the first device may determine, based on the interleaving pattern corresponding to K=11 in Table 29, specific positions in which puncturing is to be performed. For example, when K=11 and E=14, interleaving needs to be performed on the first codeword sequence whose length is 32 based on Table 29, to obtain the second codeword sequence, and then puncturing is sequentially performed from back to front for 18 times. To be specific, bits in positions {22,19,28,9,4,6,14,11,3,13,0,15,26,24,27,18,21,19} of the first codeword sequence are punctured. For another example, when K=7 and E=22, interleaving needs to be performed on the first codeword sequence whose length is 32 based on Table 29, to obtain the second codeword sequence, and then puncturing is sequentially performed from back to front for 10 times. To be specific, bits in positions {7,9,19,26,31,21,27,2,22,17} of the first codeword sequence are punctured.

The following describes in detail another rate matching method provided in this application.

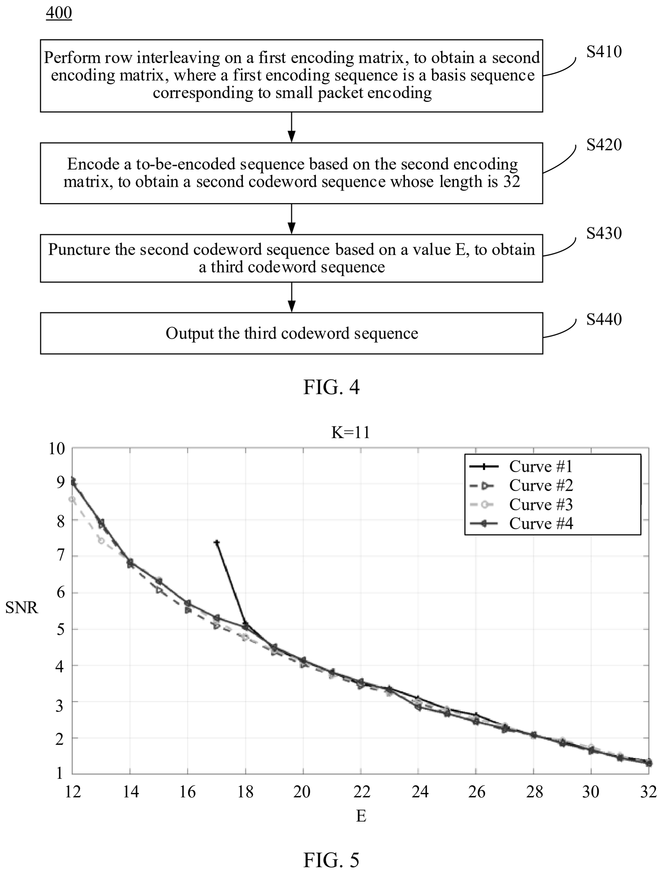

FIG. 4 is a schematic flowchart of another rate matching method 400 according to this application. The method includes the following steps.

S410: A first device performs row interleaving on a first encoding sequence, to obtain a second encoding sequence, where the first encoding sequence is a basis sequence corresponding to small packet encoding.

The first encoding sequence is a matrix with 32 rows and 11 columns. Performing row interleaving on the first encoding sequence specifically refers to performing adjustment on all or a part of the 32 rows in the first encoding sequence. When positions of at least two rows in the 32 rows in the first encoding sequence change, it may be considered that row interleaving is performed on the first encoding sequence. It should be noted that the row interleaving indicates that positions of row elements in the sequence are adjusted. Therefore, the second encoding sequence is also a sequence with 32 rows and 11 columns.

In a possible implementation, the first encoding sequence is the encoding sequences shown in Table 1.

Optionally, that the first device performs row interleaving on the first encoding sequence includes: The first device performs row interleaving on the first encoding sequence based on a first interleaving pattern, where the first interleaving pattern is used for resetting positions of all or a part of the 32 rows in the first encoding sequence.

The following describes the row interleaving operation in S410 by using an example. For example, the first encoding sequence is shown in Table 1, the first interleaving pattern is shown in Table 2, and the second encoding sequence obtained by performing row interleaving on the first encoding sequence shown in Table 1 based on Table 2 is shown in Table 30.

Table 30

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 1 | 1 | 1 | 1 | 1 | 1 | 1 | 1 | 1 |
| 1 | 1 | 1 | 0 | 1 | 0 | 1 | 0 | 1 | 0 | 1 | 1 |
| 2 | 1 | 0 | 0 | 0 | 1 | 0 | 0 | 1 | 1 | 0 | 1 |
| 3 | 1 | 0 | 1 | 1 | 0 | 0 | 0 | 0 | 1 | 0 | 1 |
| 4 | 1 | 0 | 0 | 1 | 1 | 1 | 0 | 0 | 1 | 0 | 0 |
| 5 | 1 | 1 | 0 | 0 | 1 | 1 | 1 | 1 | 0 | 1 | 1 |
| 6 | 1 | 1 | 1 | 1 | 0 | 0 | 0 | 1 | 0 | 0 | 1 |
| 7 | 1 | 1 | 1 | 0 | 0 | 0 | 0 | 0 | 0 | 1 | 1 |
| 8 | 1 | 0 | 1 | 0 | 1 | 1 | 1 | 0 | 1 | 0 | 0 |
| 9 | 1 | 1 | 0 | 1 | 1 | 1 | 1 | 1 | 0 | 0 | 0 |
| 10 | 1 | 0 | 0 | 0 | 0 | 1 | 1 | 0 | 0 | 0 | 0 |
| 11 | 1 | 0 | 0 | 1 | 0 | 1 | 0 | 1 | 1 | 1 | 1 |
| 12 | 1 | 1 | 0 | 0 | 1 | 0 | 1 | 1 | 1 | 0 | 1 |
| 13 | 1 | 1 | 1 | 0 | 1 | 0 | 0 | 0 | 1 | 1 | 1 |
| 14 | 1 | 0 | 1 | 0 | 0 | 1 | 1 | 1 | 0 | 1 | 1 |
| 15 | 1 | 1 | 0 | 0 | 0 | 1 | 1 | 1 | 0 | 0 | 1 |
| 16 | 1 | 0 | 1 | 1 | 0 | 1 | 0 | 0 | 1 | 1 | 0 |
| 17 | 1 | 0 | 0 | 1 | 0 | 0 | 1 | 0 | 1 | 1 | 1 |
| 18 | 1 | 0 | 1 | 1 | 1 | 1 | 1 | 1 | 1 | 0 | 0 |
| 19 | 1 | 1 | 0 | 1 | 0 | 0 | 0 | 0 | 0 | 1 | 1 |
| 20 | 1 | 1 | 1 | 1 | 1 | 0 | 1 | 1 | 1 | 1 | 0 |
| 21 | 1 | 1 | 1 | 0 | 1 | 1 | 1 | 0 | 0 | 1 | 0 |
| 22 | 1 | 0 | 0 | 1 | 1 | 0 | 0 | 1 | 1 | 0 | 1 |
| 23 | 1 | 0 | 1 | 0 | 0 | 0 | 1 | 0 | 0 | 0 | 1 |
| 24 | 1 | 0 | 0 | 0 | 0 | 0 | 0 | 0 | 0 | 0 | 0 |
| 25 | 1 | 0 | 1 | 1 | 1 | 0 | 1 | 0 | 0 | 1 | 1 |
| 26 | 1 | 1 | 1 | 0 | 0 | 1 | 1 | 0 | 1 | 0 | 1 |
| 27 | 1 | 1 | 0 | 0 | 0 | 0 | 0 | 0 | 0 | 0 | 1 |
| 28 | 1 | 0 | 1 | 0 | 1 | 0 | 1 | 0 | 1 | 1 | 1 |
| 29 | 1 | 0 | 0 | 0 | 1 | 1 | 0 | 1 | 0 | 0 | 1 |
| 30 | 1 | 1 | 1 | 1 | 0 | 1 | 0 | 1 | 1 | 1 | 0 |
| 31 | 1 | 1 | 0 | 1 | 1 | 0 | 0 | 1 | 0 | 1 | 1 |

Optionally, the first interleaving pattern indicates that last M rows in the second encoding sequence obtained by performing row interleaving on the first encoding sequence based on the first interleaving pattern are the same as last M rows in the first encoding sequence. For example, M=12, the first encoding sequence is shown in Table 1, the first interleaving pattern is shown in Table 3, and the second encoding sequence obtained by performing row interleaving on the first encoding sequence shown in Table 1 based on Table 3 is shown in Table 31. Last 12 rows in Table 31 is the same as that in Table 1.

Table 31

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 1 | 0 | 1 | 1 | 1 | 0 | 0 | 1 | 0 |
| 1 | 1 | 0 | 0 | 0 | 1 | 1 | 0 | 1 | 0 | 0 | 1 |
| 2 | 1 | 0 | 1 | 1 | 0 | 0 | 0 | 0 | 1 | 0 | 1 |
| 3 | 1 | 1 | 0 | 0 | 0 | 0 | 0 | 0 | 0 | 0 | 1 |
| 4 | 1 | 1 | 1 | 1 | 0 | 0 | 0 | 1 | 0 | 0 | 1 |
| 5 | 1 | 0 | 0 | 1 | 1 | 0 | 0 | 1 | 1 | 0 | 1 |
| 6 | 1 | 0 | 1 | 1 | 1 | 0 | 1 | 0 | 0 | 1 | 1 |
| 7 | 1 | 0 | 1 | 0 | 1 | 0 | 1 | 0 | 1 | 1 | 1 |
| 8 | 1 | 1 | 0 | 0 | 1 | 1 | 1 | 1 | 0 | 1 | 1 |
| 9 | 1 | 1 | 1 | 0 | 0 | 0 | 0 | 0 | 0 | 1 | 1 |
| 10 | 1 | 1 | 0 | 1 | 1 | 0 | 0 | 1 | 0 | 1 | 1 |
| 11 | 1 | 1 | 0 | 1 | 0 | 1 | 0 | 1 | 0 | 1 | 1 |
| 12 | 1 | 0 | 1 | 0 | 0 | 1 | 1 | 1 | 0 | 1 | 1 |
| 13 | 1 | 0 | 0 | 1 | 1 | 1 | 0 | 0 | 1 | 0 | 0 |
| 14 | 1 | 1 | 0 | 0 | 1 | 0 | 1 | 1 | 1 | 0 | 1 |
| 15 | 1 | 0 | 0 | 0 | 0 | 1 | 1 | 0 | 0 | 0 | 0 |
| 16 | 1 | 0 | 0 | 1 | 0 | 1 | 0 | 1 | 1 | 1 | 1 |
| 17 | 1 | 1 | 1 | 0 | 0 | 1 | 1 | 0 | 1 | 0 | 1 |
| 18 | 1 | 0 | 0 | 1 | 0 | 0 | 1 | 0 | 1 | 1 | 1 |
| 19 | 1 | 1 | 0 | 1 | 1 | 1 | 1 | 1 | 0 | 0 | 0 |
| 20 | 1 | 0 | 1 | 0 | 0 | 0 | 1 | 0 | 0 | 0 | 1 |
| 21 | 1 | 1 | 0 | 1 | 0 | 0 | 0 | 0 | 0 | 1 | 1 |
| 22 | 1 | 0 | 0 | 0 | 1 | 0 | 0 | 1 | 1 | 0 | 1 |
| 23 | 1 | 1 | 1 | 0 | 1 | 0 | 0 | 0 | 1 | 1 | 1 |
| 24 | 1 | 1 | 1 | 1 | 1 | 0 | 1 | 1 | 1 | 1 | 0 |
| 25 | 1 | 1 | 0 | 0 | 0 | 1 | 1 | 1 | 0 | 0 | 1 |
| 26 | 1 | 0 | 1 | 1 | 0 | 1 | 0 | 0 | 1 | 1 | 0 |
| 27 | 1 | 1 | 1 | 1 | 0 | 1 | 0 | 1 | 1 | 1 | 0 |
| 28 | 1 | 0 | 1 | 0 | 1 | 1 | 1 | 0 | 1 | 0 | 0 |
| 29 | 1 | 0 | 1 | 1 | 1 | 1 | 1 | 1 | 1 | 0 | 0 |
| 30 | 1 | 1 | 1 | 1 | 1 | 1 | 1 | 1 | 1 | 1 | 1 |
| 31 | 1 | 0 | 0 | 0 | 0 | 0 | 0 | 0 | 0 | 0 | 0 |

S420: The first device encodes a to-be-encoded sequence based on the second encoding sequence, to obtain a second codeword sequence whose length is 32.

For example, a length of the to-be-encoded sequence is K, and 3<K< 11.

It may be understood that, when the first encoding sequence is the sequences shown in Table 1, a difference between the method shown in FIG. 2 and the method shown in FIG. 4 lies in that in the method shown in FIG. 2, the to-be-encoded sequence is first encoded based on the first encoding sequence, to obtain the first codeword sequence, and then the first codeword sequence is interleaved based on the first interleaving pattern, to obtain the second codeword sequence; and in the method shown in FIG. 4, row interleaving is first performed on the first encoding sequence based on the first interleaving pattern, to obtain the second encoding sequence, and then, the to-be-encoded sequence is encoded based on the second encoding sequence, to obtain the second codeword sequence. This may also be understood as that in the methods shown in FIG. 2 and FIG. 4, when the first encoding sequences are the same, the to-be-encoded sequences are the same, and the first interleaving patterns are the same, the second codeword sequences obtained in the methods shown in FIG. 2 and FIG. 4 are also the same.

S430: The first device punctures the second codeword sequence based on a value E, to obtain a third codeword sequence, where the value E indicates a quantity of bits of the second codeword sequence after rate matching, and E is a positive integer less than 32.

For S430, refer to the descriptions of S230. Details are not described herein again.

S440: The first device outputs the third codeword sequence.

In addition, for a manner of obtaining the first interleaving pattern in the method, refer to the descriptions of the search algorithms respectively corresponding to cases in which K is nested and K is not nested in FIG. 2. Details are not described herein again.

The foregoing describes in detail the method provided in this application. In an example, the following provides, based on the method provided in this application, a diagram of a simulation result of rate matching performed when K=11.

FIG. 5 is a simulation comparison diagram of performance corresponding to four different rate matching methods when K=11. FIG. 5 includes four curves, and the four curves correspond to the four different rate matching methods. A horizontal axis in FIG. 5 is a code length E after puncturing, a value of the code length E ranges from K+1 to N (that is, the value of the code length E ranges from 12 to 32), and a vertical axis is an SNR corresponding to BLER=0.01. A curve #1 marked with a "cross" is a performance simulation diagram corresponding to an existing rate matching method, a curve #2 marked with a right-pointing triangle is a performance simulation diagram in a case in which when the first encoding sequence in the method shown in FIG. 2 is the encoding sequences shown in Table 14, a puncturing sequence (that is, Table 12) is specifically designed for K=11 to perform rate matching, and a curve #3 marked as pointing to the left is a performance simulation diagram in a case in which when the first encoding sequence in the method shown in FIG. 2 (or FIG. 4) is the encoding sequences shown in Table 1, rate matching is performed based on Table 2. Simulation channels corresponding to the curve #1, the curve #2, and the curve #3 are additive white Gaussian noise (additive white Gaussian noise, AWGN) channels, modulation schemes are quadrature phase shift keying (quadrature phase shift keying, QPSK) modulation, encoding schemes are LTE-RM code in Table 1 or Table 14 corresponding to all the curves, and decoding schemes are fast Hadamard transform (fast hadamard transform, FHT) decoding. A curve #4 marked with a circle is a currently known best performance baseline. A simulation channel corresponding to the curve is an AWGN channel, a modulation scheme is QPSK modulation, an encoding scheme is parity check (parity check, PC)-polar (Polar) code, and a decoding scheme is successive cancellation list (successive cancellation list, SCL) 8 decoding.

It can be learned from FIG. 5 that the curve #1 has a performance bad point when E=12 to 17. To be specific, when K=11 and E= 12 to 17, a value of first performance of a puncturing sequence output based on the existing rate matching method does not exist, and the value of the first performance is a value of the SNR corresponding to BLER=0.01. However, the simulation curve #2 and the curve #4 obtained based on this embodiment of this application have no performance bad point when E=12 to 17, and are closer to the curve marked with the circle.

It may be understood that the steps in the foregoing accompanying drawings are merely examples for description, and these are not strictly limited. In addition, sequence numbers of the foregoing processes do not mean a sequence of execution. The sequence of execution of the processes should be determined based on functions and internal logic of the processes, and should not constitute any limitation on an implementation process of this embodiment of this application.

It may be further understood that some encoding sequence names in embodiments of this application do not limit the protection scope of embodiments of this application.

It may be further understood that some optional features in embodiments of this application may be independent of other features in some scenarios, or may be combined with other features in some scenarios. This is not limited.

It can also be understood that in the foregoing method embodiments, the methods and operations implemented by the first device may be alternatively implemented by a component (for example, a chip or a circuit) of the first device. This is not limited.

In correspondence to the method provided in the foregoing method embodiments, an embodiment of this application further provides a corresponding apparatus. The apparatus includes a corresponding module configured to perform the foregoing method embodiments. The module may be software, hardware, or a combination of the software and the hardware. It may be understood that the technical features described in the method embodiments are also applicable to the following apparatus embodiments.

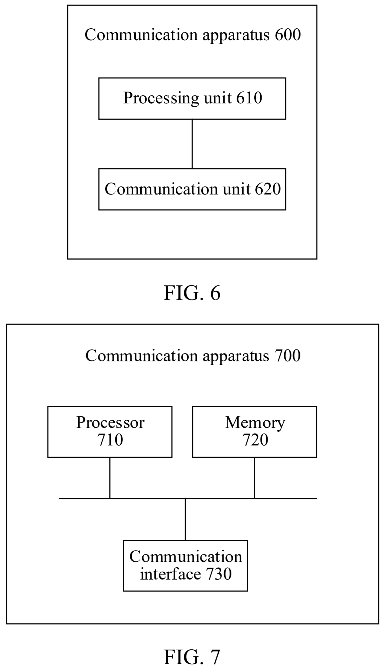

FIG. 6 is a block diagram of a communication apparatus 600 according to this application. As shown in FIG. 6, the communication apparatus 600 includes a processing unit 610 and a communication unit 620. The apparatus 600 may implement steps or procedures performed by the first device in the foregoing method embodiments. The processing unit 610 is configured to perform processing-related operations of the first device in the foregoing method embodiments, and the communication unit 620 is configured to perform sending-related operations of the first device in the foregoing method embodiments. For example, the units of the communication apparatus 600 are configured to implement the following functions.

The processing unit 610 is configured to encode a to-be-encoded sequence based on a first encoding sequence, to obtain a first codeword sequence whose length is 32 bits, where the first encoding sequence is a basis sequence corresponding to small packet encoding. The processing unit 610 is further configured to interleave the first codeword sequence, to obtain a second codeword sequence. The processing unit 610 is further configured to puncture the second codeword sequence based on a value E, to obtain a third codeword sequence, where the value E indicates a quantity of bits after rate matching in the second codeword sequence, and E is a positive integer less than 32. The communication unit 620 is configured to output the third codeword sequence.

In embodiments in which the communication apparatus 600 corresponds to a transmitter, the processing unit 610 is configured to perform processing and/or an operation, other than sending and receiving actions, implemented inside the first device. The communication unit 620 is configured to perform a receiving (or input) action of the first device, and/or configured to perform a sending (or output) action of the first device.

It should be understood that the apparatus 600 herein is embodied in a form of a functional unit. The term "unit" herein may refer to an application-specific integrated circuit (application-specific integrated circuit, ASIC), an electronic circuit, a processor (for example, a shared processor, a dedicated processor, or a group processor) configured to execute one or more software or firmware programs, a memory, a merged logic circuit, and/or another appropriate component that supports the described function.

The apparatus 600 in each of the foregoing solutions has a function of implementing corresponding steps performed by the first device in the foregoing methods. The function may be implemented by hardware, or may be implemented by hardware executing corresponding software. The hardware or software includes one or more modules corresponding to the foregoing function. For example, the communication unit may be replaced with a transceiver (for example, a sending unit in the communication unit may be replaced with a transmitter, and a receiving unit in the communication unit may be replaced with a receiver), and another unit such as the processing unit may be replaced with a processor, to separately perform the sending/receiving operations and the processing-related operations in the method embodiments.

In addition, alternatively, the communication unit may be a transceiver circuit (for example, may include a receiving circuit and a sending circuit), and the processing unit may be a processing circuit. In this embodiment of this application, the apparatus 600 may be the first device in the foregoing embodiments, or may be a chip or a chip system, for example, a system on chip (system on chip, SoC). The communication unit may be an input/output circuit or a communication interface. The processing unit is a processor, a microprocessor, or an integrated circuit integrated on the chip. This is not limited herein.

FIG. 7 is a diagram of a structure of a communication apparatus 700 according to this application. As shown in FIG. 7, the communication apparatus 700 includes one or more processors 710, one or more memories 720, and one or more communication interfaces 730. The processor 710 is configured to control the communication interface 730 to receive and transmit signals. The memory 720 is configured to store a computer program. The processor 710 is configured to invoke the computer program from the memory 720 and run the computer program, so that the communication apparatus 800 performs processing performed by the transmitter or the receiver in the method embodiments of this application.

For example, the processor 710 may have a function of the processing unit 610 shown in FIG. 6, and the communication interface 730 may have a function of the communication unit 620 shown in FIG. 6. Specifically, the processor 710 may be configured to perform processing or operations performed inside the communication apparatus, and the communication interface 730 is configured to perform a sending and/or receiving operation performed by the communication apparatus.

Optionally, the memory and the processor in each of the foregoing apparatus embodiments may be units physically independent of each other, or the memory may be integrated with the processor. This is not limited in this application.

In addition, this application further provides a computer-readable storage medium. The computer-readable storage medium stores computer instructions. When the computer instructions are run on a computer, an operation and/or processing performed by the first device in the method embodiments of this application are/is performed.

In addition, this application further provides a computer program product. The computer program product includes computer program code or instructions. When the computer program code or the instructions are run on a computer, an operation and/or processing performed by the first device in the method embodiments of this application are/is performed.

In addition, this application further provides a chip. The chip includes a processor. A memory configured to store a computer program is disposed independent of the chip. The processor is configured to execute the computer program stored in the memory, to enable an apparatus in which the chip is installed to perform an operation and/or processing performed by the first device in any one of the method embodiments.

Further, the chip may include a communication interface. The communication interface may be an input/output interface, an interface circuit, or the like. Further, the chip may include the memory.

Optionally, there may be one or more processors, there may be one or more memories, and there may be one or more memories.

In addition, this application further provides a communication apparatus (for example, a chip or a chip system), including a processor and a communication interface. According to an operation and/or processing performed by the first device in any one of the foregoing method embodiments, the communication interface is configured to receive (or referred to as input) a to-be-encoded message bit, and the processor encodes the to-be-encoded message bit. Optionally, the communication interface is further configured to send (or referred to as output) data and/or information processed by the processor.

In addition, this application further provides a communication apparatus, including at least one processor. The at least one processor is coupled to at least one memory. The at least one processor is configured to execute a computer program or instructions stored in the at least one memory, to enable the communication apparatus to perform an operation and/or processing performed by the first device in any one of the method embodiments.

In addition, this application further provides a communication system, including the first device in the method embodiments of this application.

The memory in embodiments of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. Through example but not limitative description, RAMs in many forms are available, such as a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DRRAM). It should be noted that the memory of the systems and methods described in this specification includes but is not limited to these and any memory of another proper type.

All or some of the methods provided in the foregoing embodiments may be implemented by software, hardware, firmware, or any combination thereof. When software is used to implement embodiments, all or a part of embodiments may be implemented in a form of a computer program product. The computer program product may include one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media.

To clearly describe the technical solutions in embodiments of this application, numbers such as "first" and "second" are used in embodiments of this application to distinguish between same items or similar items that provide basically same functions. A person skilled in the art may understand that the numbers such as "first" and "second" do not limit the number and an execution sequence, and the words such as "first" and "second" do not necessarily indicate a definite difference.

In embodiments of this application, "at least one" means one or more, and "plurality of" means two or more. "And/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In several embodiments provided in this application, it should be understood that the disclosed system, apparatus, and method may be implemented in other manners. For example, the described apparatus embodiments are merely examples. For example, division into the units is merely logical function division. There may be another division manner during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

**Claims**

1.  A rate matching method, comprising:

    encoding a to-be-encoded sequence based on a first encoding sequence, to obtain a first codeword sequence whose length is 32 bits, wherein the first encoding sequence is a basis sequence corresponding to small packet encoding;
    interleaving the first codeword sequence to obtain a second codeword sequence;
    puncturing the second codeword sequence based on a value E, to obtain a third codeword sequence, wherein the value E indicates a quantity of bits of the second codeword sequence after rate matching, and E is a positive integer less than 32; and
    outputting the third codeword sequence.

2.  The method according to claim 1, wherein the interleaving the first codeword sequence comprises:
    interleaving the first codeword sequence based on a first interleaving pattern, wherein the first interleaving pattern is used for resetting positions of all or a part of the 32 bits of the first codeword sequence.

3.  The method according to claim 2, wherein the first encoding sequence is a matrix with 32 rows and 11 columns, the first encoding sequence is shown in the following table, i represents a row index of the matrix, and M represents a column index of the matrix.

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 0 | 0 | 0 | 0 | 0 | 0 | 0 | 0 | 1 |
| 1 | 1 | 1 | 1 | 0 | 0 | 0 | 0 | 0 | 0 | 1 | 1 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 2 | 1 | 0 | 0 | 1 | 0 | 0 | 1 | 0 | 1 | 1 | 1 |
| 3 | 1 | 0 | 1 | 1 | 0 | 0 | 0 | 0 | 1 | 0 | 1 |
| 4 | 1 | 1 | 1 | 1 | 0 | 0 | 0 | 1 | 0 | 0 | 1 |
| 5 | 1 | 1 | 0 | 0 | 1 | 0 | 1 | 1 | 1 | 0 | 1 |
| 6 | 1 | 0 | 1 | 0 | 1 | 0 | 1 | 0 | 1 | 1 | 1 |
| 7 | 1 | 0 | 0 | 1 | 1 | 0 | 0 | 1 | 1 | 0 | 1 |
| 8 | 1 | 1 | 0 | 1 | 1 | 0 | 0 | 1 | 0 | 1 | 1 |
| 9 | 1 | 0 | 1 | 1 | 1 | 0 | 1 | 0 | 0 | 1 | 1 |
| 10 | 1 | 0 | 1 | 0 | 0 | 1 | 1 | 1 | 0 | 1 | 1 |
| 11 | 1 | 1 | 1 | 0 | 0 | 1 | 1 | 0 | 1 | 0 | 1 |
| 12 | 1 | 0 | 0 | 1 | 0 | 1 | 0 | 1 | 1 | 1 | 1 |
| 13 | 1 | 1 | 0 | 1 | 0 | 1 | 0 | 1 | 0 | 1 | 1 |
| 14 | 1 | 0 | 0 | 0 | 1 | 1 | 0 | 1 | 0 | 0 | 1 |
| 15 | 1 | 1 | 0 | 0 | 1 | 1 | 1 | 1 | 0 | 1 | 1 |
| 16 | 1 | 1 | 1 | 0 | 1 | 1 | 1 | 0 | 0 | 1 | 0 |
| 17 | 1 | 0 | 0 | 1 | 1 | 1 | 0 | 0 | 1 | 0 | 0 |
| 18 | 1 | 1 | 0 | 1 | 1 | 1 | 1 | 1 | 0 | 0 | 0 |
| 19 | 1 | 0 | 0 | 0 | 0 | 1 | 1 | 0 | 0 | 0 | 0 |
| 20 | 1 | 0 | 1 | 0 | 0 | 0 | 1 | 0 | 0 | 0 | 1 |
| 21 | 1 | 1 | 0 | 1 | 0 | 0 | 0 | 0 | 0 | 1 | 1 |
| 22 | 1 | 0 | 0 | 0 | 1 | 0 | 0 | 1 | 1 | 0 | 1 |
| 23 | 1 | 1 | 1 | 0 | 1 | 0 | 0 | 0 | 1 | 1 | 1 |
| 24 | 1 | 1 | 1 | 1 | 1 | 0 | 1 | 1 | 1 | 1 | 0 |
| 25 | 1 | 1 | 0 | 0 | 0 | 1 | 1 | 1 | 0 | 0 | 1 |
| 26 | 1 | 0 | 1 | 1 | 0 | 1 | 0 | 0 | 1 | 1 | 0 |
| 27 | 1 | 1 | 1 | 1 | 0 | 1 | 0 | 1 | 1 | 1 | 0 |
| 28 | 1 | 0 | 1 | 0 | 1 | 1 | 1 | 0 | 1 | 0 | 0 |
| 29 | 1 | 0 | 1 | 1 | 1 | 1 | 1 | 1 | 1 | 0 | 0 |
| 30 | 1 | 1 | 1 | 1 | 1 | 1 | 1 | 1 | 1 | 1 | 1 |
| 31 | 1 | 0 | 0 | 0 | 0 | 0 | 0 | 0 | 0 | 0 | 0 |

4. The method according to claim 2 or 3, wherein a length of the to-be-encoded sequence is K, and when K is any value in 3 to 11, the first interleaving pattern is shown in Table #1 or Table #2 below:

Table #1

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 17 | 8 | 28 | 12 | 5 | 16 | 26 | 20 | 24 | 24 | 31 | 28 | 6 |
| 1 | 13 | 5 | 15 | 9 | 18 | 13 | 23 | 17 | 2 | 21 | 16 | 25 | 9 | 29 | 14 |
| 2 | 22 | 6 | 4 | 10 | 19 | 14 | 10 | 18 | 29 | 22 | 7 | 26 | 11 | 30 | 27 |
| 3 | 3 | 7 | 1 | 11 | 12 | 15 | 25 | 19 | 21 | 23 | 20 | 27 | 0 | 31 | 8 |

Table #2

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 16 | 4 | 4 | 8 | 15 | 12 | 10 | 16 | 12 | 20 | 20 | 24 | 24 | 28 | 28 |
| 1 | 14 | 5 | 7 | 9 | 1 | 13 | 17 | 17 | 11 | 21 | 21 | 25 | 25 | 29 | 29 |
| 2 | 3 | 6 | 9 | 10 | 8 | 14 | 5 | 18 | 2 | 22 | 22 | 26 | 26 | 30 | 30 |
| 3 | 0 | 7 | 6 | 11 | 13 | 15 | 19 | 19 | 18 | 23 | 23 | 27 | 27 | 31 | 31 |

wherein i represents an $(i+1)^{th}$ position of the second codeword sequence, P(i) represents a bit that is in a $(P(i)+1)^{th}$ position of the first codeword sequence and that is placed in the $(i+1)^{th}$ position of the second codeword sequence, and $0 \le i \le 31$.

5. The method according to claim 2 or 3, wherein a length of the to-be-encoded sequence is K, and

when K is equal to 3, the first interleaving pattern is shown in Table #3:

Table #3

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 28 | 4 | 22 | 8 | 2 | 12 | 1 | 16 | 4 | 20 | 27 | 24 | 18 | 28 | 10 |
| 1 | 14 | 5 | 16 | 9 | 29 | 13 | 31 | 17 | 13 | 21 | 17 | 25 | 9 | 29 | 11 |
| 2 | 25 | 6 | 8 | 10 | 30 | 14 | 15 | 18 | 3 | 22 | 6 | 26 | 24 | 30 | 5 |
| 3 | 23 | 7 | 26 | 11 | 21 | 15 | 20 | 19 | 12 | 23 | 19 | 27 | 0 | 31 | 7 |

or when K is equal to 4, the first interleaving pattern is shown in Table #4:

Table #4

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 20 | 8 | 6 | 12 | 12 | 16 | 13 | 20 | 9 | 24 | 28 | 28 | 7 |
| 1 | 29 | 5 | 14 | 9 | 3 | 13 | 25 | 17 | 0 | 21 | 4 | 25 | 27 | 29 | 5 |
| 2 | 21 | 6 | 15 | 10 | 24 | 14 | 23 | 18 | 11 | 22 | 31 | 26 | 26 | 30 | 18 |
| 3 | 1 | 7 | 17 | 11 | 19 | 15 | 8 | 19 | 22 | 23 | 2 | 27 | 16 | 31 | 10 |

or when K is equal to 5, the first interleaving pattern is shown in Table #5:

Table #5

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 4 | 8 | 3 | 12 | 16 | 16 | 25 | 20 | 24 | 24 | 21 | 28 | 15 |
| 1 | 17 | 5 | 0 | 9 | 13 | 13 | 10 | 17 | 6 | 21 | 27 | 25 | 19 | 29 | 7 |
| 2 | 14 | 6 | 5 | 10 | 11 | 14 | 29 | 18 | 23 | 22 | 9 | 26 | 26 | 30 | 12 |
| 3 | 8 | 7 | 28 | 11 | 2 | 15 | 31 | 19 | 1 | 23 | 18 | 27 | 22 | 31 | 20 |

or when K is equal to 6, the first interleaving pattern is shown in Table #6:

Table #6

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 29 | 4 | 7 | 8 | 25 | 12 | 5 | 16 | 3 | 20 | 20 | 24 | 22 | 28 | 10 |
| 1 | 16 | 5 | 21 | 9 | 4 | 13 | 6 | 17 | 15 | 21 | 8 | 25 | 13 | 29 | 19 |

(continued)

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 2 | 26 | 6 | 1 | 10 | 28 | 14 | 9 | 18 | 14 | 22 | 2 | 26 | 31 | 30 | 27 |
| 3 | 24 | 7 | 0 | 11 | 30 | 15 | 17 | 19 | 12 | 23 | 23 | 27 | 18 | 31 | 11 |

or when K is equal to 7, the first interleaving pattern is shown in Table #7:

Table #7

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 17 | 4 | 22 | 8 | 1 | 12 | 7 | 16 | 19 | 20 | 29 | 24 | 20 | 28 | 28 |
| 1 | 26 | 5 | 3 | 9 | 8 | 13 | 12 | 17 | 31 | 21 | 6 | 25 | 16 | 29 | 11 |
| 2 | 24 | 6 | 21 | 10 | 10 | 14 | 23 | 18 | 14 | 22 | 25 | 26 | 13 | 30 | 5 |
| 3 | 9 | 7 | 0 | 11 | 18 | 15 | 2 | 19 | 15 | 23 | 27 | 27 | 30 | 31 | 4 |

or when K is equal to 8, the first interleaving pattern is shown in Table #8:

Table #8

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 15 | 8 | 31 | 12 | 27 | 16 | 1 | 20 | 29 | 24 | 12 | 28 | 9 |
| 1 | 17 | 5 | 10 | 9 | 18 | 13 | 7 | 17 | 20 | 21 | 4 | 25 | 13 | 29 | 5 |
| 2 | 16 | 6 | 8 | 10 | 6 | 14 | 26 | 18 | 3 | 22 | 0 | 26 | 14 | 30 | 19 |
| 3 | 28 | 7 | 2 | 11 | 11 | 15 | 22 | 19 | 23 | 23 | 21 | 27 | 25 | 31 | 24 |

or when K is equal to 9, the first interleaving pattern is shown in Table #9:

Table #9

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 7 | 8 | 1 | 12 | 3 | 16 | 27 | 20 | 20 | 24 | 18 | 28 | 9 |
| 1 | 16 | 5 | 23 | 9 | 0 | 13 | 8 | 17 | 28 | 21 | 4 | 25 | 22 | 29 | 24 |
| 2 | 12 | 6 | 6 | 10 | 31 | 14 | 29 | 18 | 15 | 22 | 19 | 26 | 14 | 30 | 13 |
| 3 | 10 | 7 | 21 | 11 | 26 | 15 | 17 | 19 | 5 | 23 | 11 | 27 | 2 | 31 | 25 |

or when K is equal to 10, the first interleaving pattern is shown in Table #10:

Table #10

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 16 | 4 | 25 | 8 | 3 | 12 | 23 | 16 | 7 | 20 | 21 | 24 | 29 | 28 | 28 |
| 1 | 15 | 5 | 24 | 9 | 1 | 13 | 0 | 17 | 19 | 21 | 6 | 25 | 14 | 29 | 9 |
| 2 | 11 | 6 | 8 | 10 | 20 | 14 | 13 | 18 | 2 | 22 | 30 | 26 | 27 | 30 | 18 |
| 3 | 10 | 7 | 4 | 11 | 26 | 15 | 5 | 19 | 12 | 23 | 31 | 27 | 22 | 31 | 17 |

or when K is equal to 11, the first interleaving pattern is shown in Table #11:

Table #11

| i | P(i) | i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|---|---|
| 0 | 30 | 4 | 27 | 8 | 4 | 12 | 7 | 16 | 10 | 20 | 24 | 24 | 23 | 28 | 5 |
| 1 | 29 | 5 | 19 | 9 | 21 | 13 | 12 | 17 | 16 | 21 | 31 | 25 | 9 | 29 | 17 |
| 2 | 18 | 6 | 6 | 10 | 20 | 14 | 25 | 18 | 14 | 22 | 8 | 26 | 3 | 30 | 11 |
| 3 | 15 | 7 | 22 | 11 | 0 | 15 | 13 | 19 | 28 | 23 | 1 | 27 | 2 | 31 | 26 |

wherein i represents an $(i+1)^{th}$ position of the second codeword sequence, P(i) represents a bit that is in a $(P(i)+1)^{th}$ position of the first codeword sequence and that is placed in the $(i+1)^{th}$ position of the second codeword sequence, and $0 \leq i \leq 31$.

6. The method according to claim 2, wherein the first encoding sequence is a matrix with 32 rows and 11 columns, the first encoding sequence is shown in the following table, i represents a row index of the matrix, and M represents a column index of the matrix:

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 0 | 0 | 0 | 0 | 0 | 0 | 0 | 0 | 0 | 0 |
| 1 | 1 | 1 | 0 | 0 | 0 | 0 | 0 | 0 | 0 | 0 | 1 |
| 2 | 1 | 0 | 1 | 0 | 0 | 0 | 1 | 0 | 0 | 0 | 1 |
| 3 | 1 | 1 | 1 | 0 | 0 | 0 | 0 | 0 | 0 | 1 | 1 |
| 4 | 1 | 0 | 0 | 1 | 0 | 0 | 1 | 0 | 1 | 1 | 1 |
| 5 | 1 | 1 | 0 | 1 | 0 | 0 | 0 | 0 | 0 | 1 | 1 |
| 6 | 1 | 0 | 1 | 1 | 0 | 0 | 0 | 0 | 1 | 0 | 1 |
| 7 | 1 | 1 | 1 | 1 | 0 | 0 | 0 | 1 | 0 | 0 | 1 |
| 8 | 1 | 0 | 0 | 0 | 1 | 0 | 0 | 1 | 1 | 0 | 1 |
| 9 | 1 | 1 | 0 | 0 | 1 | 0 | 1 | 1 | 1 | 0 | 1 |
| 10 | 1 | 0 | 1 | 0 | 1 | 0 | 1 | 0 | 1 | 1 | 1 |
| 11 | 1 | 1 | 1 | 0 | 1 | 0 | 0 | 0 | 1 | 1 | 1 |
| 12 | 1 | 0 | 0 | 1 | 1 | 0 | 0 | 1 | 1 | 0 | 1 |
| 13 | 1 | 1 | 0 | 1 | 1 | 0 | 0 | 1 | 0 | 1 | 1 |
| 14 | 1 | 0 | 1 | 1 | 1 | 0 | 1 | 0 | 0 | 1 | 1 |
| 15 | 1 | 1 | 1 | 1 | 1 | 0 | 1 | 1 | 1 | 1 | 0 |
| 16 | 1 | 0 | 0 | 0 | 0 | 1 | 1 | 0 | 0 | 0 | 0 |
| 17 | 1 | 1 | 0 | 0 | 0 | 1 | 1 | 1 | 0 | 0 | 1 |
| 18 | 1 | 0 | 1 | 0 | 0 | 1 | 1 | 1 | 0 | 1 | 1 |
| 19 | 1 | 1 | 1 | 0 | 0 | 1 | 1 | 0 | 1 | 0 | 1 |
| 20 | 1 | 0 | 0 | 1 | 0 | 1 | 0 | 1 | 1 | 1 | 1 |
| 21 | 1 | 1 | 0 | 1 | 0 | 1 | 0 | 1 | 0 | 1 | 1 |
| 22 | 1 | 0 | 1 | 1 | 0 | 1 | 0 | 0 | 1 | 1 | 0 |
| 23 | 1 | 1 | 1 | 1 | 0 | 1 | 0 | 1 | 1 | 1 | 0 |
| 24 | 1 | 0 | 0 | 0 | 1 | 1 | 0 | 1 | 0 | 0 | 1 |
| 25 | 1 | 1 | 0 | 0 | 1 | 1 | 1 | 1 | 0 | 1 | 1 |
| 26 | 1 | 0 | 1 | 0 | 1 | 1 | 1 | 0 | 1 | 0 | 0 |

(continued)

| i | M$_{i,0}$ | M$_{i,1}$ | M$_{i,2}$ | M$_{i,3}$ | M$_{i,4}$ | M$_{i,5}$ | M$_{i,6}$ | M$_{i,7}$ | M$_{i,8}$ | M$_{i,9}$ | M$_{i,10}$ |
|---|---|---|---|---|---|---|---|---|---|---|---|
| 27 | 1 | 1 | 1 | 0 | 1 | 1 | 1 | 0 | 0 | 1 | 0 |
| 28 | 1 | 0 | 0 | 1 | 1 | 1 | 0 | 0 | 1 | 0 | 0 |
| 29 | 1 | 1 | 0 | 1 | 1 | 1 | 1 | 1 | 0 | 0 | 0 |
| 30 | 1 | 0 | 1 | 1 | 1 | 1 | 1 | 1 | 1 | 0 | 0 |
| 31 | 1 | 1 | 1 | 1 | 1 | 1 | 1 | 1 | 1 | 1 | 1 |

7. The method according to claim 2 or 6, wherein a length of the to-be-encoded sequence is K, and when K is any value in 3 to 11, the first interleaving pattern is shown in the following table:

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 31 | 4 | 28 | 8 | 26 | 12 | 9 | 16 | 22 | 20 | 15 | 24 | 0 | 28 | 10 |
| 1 | 21 | 5 | 25 | 9 | 29 | 13 | 11 | 17 | 4 | 21 | 27 | 25 | 14 | 29 | 24 |
| 2 | 8 | 6 | 7 | 10 | 18 | 14 | 18 | 18 | 30 | 22 | 12 | 26 | 19 | 30 | 23 |
| 3 | 6 | 7 | 3 | 11 | 20 | 15 | 17 | 19 | 5 | 23 | 2 | 27 | 1 | 31 | 13 |

wherein i represents an (i+1)$^{th}$ position of the second codeword sequence, P(i) represents a bit that is in a (P(i) +1)$^{th}$ position of the first codeword sequence and that is placed in the (i+1)$^{th}$ position of the second codeword sequence, and $0 \leq i \leq 31$.

8. The method according to claim 2 or 6, wherein a length of the to-be-encoded sequence is K, and

when K is equal to 3, the first interleaving pattern is shown in Table #12:

Table #12

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 26 | 4 | 8 | 8 | 4 | 12 | 3 | 16 | 7 | 20 | 23 | 24 | 29 | 28 | 18 |
| 1 | 24 | 5 | 27 | 9 | 30 | 13 | 0 | 17 | 21 | 21 | 28 | 25 | 14 | 29 | 19 |
| 2 | 11 | 6 | 13 | 10 | 31 | 14 | 25 | 18 | 6 | 22 | 10 | 26 | 15 | 30 | 9 |
| 3 | 17 | 7 | 22 | 11 | 5 | 15 | 2 | 19 | 20 | 23 | 16 | 27 | 1 | 31 | 12 |

or when K is equal to 4, the first interleaving pattern is shown in Table #13:

Table #13

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 3 | 8 | 10 | 12 | 20 | 16 | 21 | 20 | 14 | 24 | 26 | 28 | 12 |
| 1 | 2 | 5 | 24 | 9 | 6 | 13 | 17 | 17 | 1 | 21 | 7 | 25 | 23 | 29 | 9 |
| 2 | 5 | 6 | 25 | 10 | 15 | 14 | 11 | 18 | 19 | 22 | 0 | 26 | 22 | 30 | 29 |
| 3 | 31 | 7 | 28 | 11 | 16 | 15 | 13 | 19 | 8 | 23 | 4 | 27 | 27 | 31 | 18 |

or when K is equal to 5, the first interleaving pattern is shown in Table #14:

Table #14

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 28 | 4 | 31 | 8 | 6 | 12 | 27 | 16 | 17 | 20 | 15 | 24 | 5 | 28 | 25 |

(continued)

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 1 | 1 | 5 | 7 | 9 | 21 | 13 | 18 | 17 | 10 | 21 | 23 | 25 | 16 | 29 | 12 |
| 2 | 13 | 6 | 9 | 10 | 19 | 14 | 30 | 18 | 11 | 22 | 14 | 26 | 22 | 30 | 20 |
| 3 | 24 | 7 | 26 | 11 | 4 | 15 | 0 | 19 | 3 | 23 | 29 | 27 | 8 | 31 | 2 |

or when K is equal to 6, the first interleaving pattern is shown in Table #15:

Table #15

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 27 | 4 | 22 | 8 | 17 | 12 | 9 | 16 | 6 | 20 | 2 | 24 | 8 | 28 | 18 |
| 1 | 12 | 5 | 3 | 9 | 7 | 13 | 10 | 17 | 25 | 21 | 13 | 25 | 21 | 29 | 16 |
| 2 | 15 | 6 | 5 | 10 | 26 | 14 | 14 | 18 | 24 | 22 | 4 | 26 | 0 | 30 | 23 |
| 3 | 30 | 7 | 1 | 11 | 31 | 15 | 28 | 19 | 20 | 23 | 11 | 27 | 29 | 31 | 19 |

or when K is equal to 7, the first interleaving pattern is shown in Table #16:

Table #16

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 8 | 4 | 28 | 8 | 3 | 12 | 12 | 16 | 16 | 20 | 30 | 24 | 2 | 28 | 26 |
| 1 | 5 | 5 | 1 | 9 | 13 | 13 | 20 | 17 | 0 | 21 | 10 | 25 | 27 | 29 | 19 |
| 2 | 14 | 6 | 15 | 10 | 18 | 14 | 11 | 18 | 24 | 22 | 17 | 26 | 21 | 30 | 9 |
| 3 | 22 | 7 | 6 | 11 | 29 | 15 | 4 | 19 | 25 | 23 | 23 | 27 | 31 | 31 | 7 |

or when K is equal to 8, the first interleaving pattern is shown in Table #17:

Table #17

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 26 | 4 | 18 | 8 | 13 | 12 | 23 | 16 | 3 | 20 | 30 | 24 | 20 | 28 | 14 |
| 1 | 31 | 5 | 0 | 9 | 29 | 13 | 12 | 17 | 2 | 21 | 7 | 25 | 21 | 29 | 9 |
| 2 | 25 | 6 | 4 | 10 | 10 | 14 | 22 | 18 | 6 | 22 | 1 | 26 | 24 | 30 | 16 |
| 3 | 28 | 7 | 27 | 11 | 19 | 15 | 8 | 19 | 11 | 23 | 5 | 27 | 17 | 31 | 15 |

or when K is equal to 9, the first interleaving pattern is shown in Table #18:

Table #18

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 1 | 4 | 27 | 8 | 31 | 12 | 6 | 16 | 23 | 20 | 2 | 24 | 29 | 28 | 14 |
| 1 | 3 | 5 | 18 | 9 | 20 | 13 | 13 | 17 | 26 | 21 | 7 | 25 | 8 | 29 | 15 |
| 2 | 5 | 6 | 10 | 10 | 0 | 14 | 30 | 18 | 25 | 22 | 16 | 26 | 24 | 30 | 21 |
| 3 | 12 | 7 | 11 | 11 | 22 | 15 | 28 | 19 | 9 | 23 | 19 | 27 | 4 | 31 | 17 |

or when K is equal to 10, the first interleaving pattern is shown in Table #19:

Table #19

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 27 | 4 | 18 | 8 | 13 | 12 | 11 | 16 | 12 | 20 | 5 | 24 | 30 | 28 | 26 |
| 1 | 6 | 5 | 2 | 9 | 7 | 13 | 1 | 17 | 16 | 21 | 10 | 25 | 24 | 29 | 14 |
| 2 | 19 | 6 | 8 | 10 | 3 | 25 | 21 | 18 | 4 | 22 | 31 | 26 | 23 | 30 | 29 |
| 3 | 17 | 7 | 15 | 11 | 22 | 15 | 9 | 19 | 20 | 23 | 0 | 27 | 9 | 31 | 28 |

or when K is equal to 11, the first interleaving pattern is shown in Table #20:

Table #20

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 5 | 4 | 29 | 8 | 16 | 12 | 12 | 16 | 18 | 20 | 15 | 24 | 11 | 28 | 9 |
| 1 | 25 | 5 | 2 | 9 | 7 | 13 | 20 | 17 | 27 | 21 | 0 | 25 | 14 | 29 | 28 |
| 2 | 10 | 6 | 31 | 10 | 8 | 14 | 17 | 18 | 24 | 22 | 13 | 26 | 6 | 30 | 19 |
| 3 | 23 | 7 | 30 | 11 | 1 | 15 | 21 | 19 | 26 | 23 | 3 | 27 | 4 | 31 | 22 |

wherein i represents an $(i+1)^{th}$ position of the second codeword sequence, P(i) represents a bit that is in a $(P(i)+1)^{th}$ position of the first codeword sequence and that is placed in the $(i+1)^{th}$ position of the second codeword sequence, and $0 \leq i \leq 31$.

9. A rate matching method, comprising:

performing row interleaving on a first encoding sequence, to obtain a second encoding sequence, wherein the first encoding sequence is a basis sequence corresponding to small packet encoding;
encoding a to-be-encoded sequence based on the second encoding sequence, to obtain a second codeword sequence whose length is 32 bits;
puncturing the second codeword sequence based on a value E, to obtain a third codeword sequence, wherein the value E indicates a quantity of bits of the second codeword sequence after rate matching, and E is a positive integer less than 32; and
outputting the third codeword sequence.

10. The method according to claim 9, wherein the performing row interleaving on the first encoding sequence comprises:
performing row interleaving on the first encoding sequence based on a first interleaving pattern, wherein the first interleaving pattern is used for resetting positions of all or a part of 32 rows in the first encoding sequence.

11. The method according to claim 10, wherein the first encoding sequence is a matrix with 32 rows and 11 columns, the first encoding sequence is shown in the following table, i represents a row index of the matrix, and M represents a column index of the matrix:

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 0 | 0 | 0 | 0 | 0 | 0 | 0 | 0 | 1 |
| 1 | 1 | 1 | 1 | 0 | 0 | 0 | 0 | 0 | 0 | 1 | 1 |
| 2 | 1 | 0 | 0 | 1 | 0 | 0 | 1 | 0 | 1 | 1 | 1 |
| 3 | 1 | 0 | 1 | 1 | 0 | 0 | 0 | 0 | 1 | 0 | 1 |
| 4 | 1 | 1 | 1 | 1 | 0 | 0 | 0 | 1 | 0 | 0 | 1 |
| 5 | 1 | 1 | 0 | 0 | 1 | 0 | 1 | 1 | 1 | 0 | 1 |
| 6 | 1 | 0 | 1 | 0 | 1 | 0 | 1 | 0 | 1 | 1 | 1 |
| 7 | 1 | 0 | 0 | 1 | 1 | 0 | 0 | 1 | 1 | 0 | 1 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 8 | 1 | 1 | 0 | 1 | 1 | 0 | 0 | 1 | 0 | 1 | 1 |
| 9 | 1 | 0 | 1 | 1 | 1 | 0 | 1 | 0 | 0 | 1 | 1 |
| 10 | 1 | 0 | 1 | 0 | 0 | 1 | 1 | 1 | 0 | 1 | 1 |
| 11 | 1 | 1 | 1 | 0 | 0 | 1 | 1 | 0 | 1 | 0 | 1 |
| 12 | 1 | 0 | 0 | 1 | 0 | 1 | 0 | 1 | 1 | 1 | 1 |
| 13 | 1 | 1 | 0 | 1 | 0 | 1 | 0 | 1 | 0 | 1 | 1 |
| 14 | 1 | 0 | 0 | 0 | 1 | 1 | 0 | 1 | 0 | 0 | 1 |
| 15 | 1 | 1 | 0 | 0 | 1 | 1 | 1 | 1 | 0 | 1 | 1 |
| 16 | 1 | 1 | 1 | 0 | 1 | 1 | 1 | 0 | 0 | 1 | 0 |
| 17 | 1 | 0 | 0 | 1 | 1 | 1 | 0 | 0 | 1 | 0 | 0 |
| 18 | 1 | 1 | 0 | 1 | 1 | 1 | 1 | 1 | 0 | 0 | 0 |
| 19 | 1 | 0 | 0 | 0 | 0 | 1 | 1 | 0 | 0 | 0 | 0 |
| 20 | 1 | 0 | 1 | 0 | 0 | 0 | 1 | 0 | 0 | 0 | 1 |
| 21 | 1 | 1 | 0 | 1 | 0 | 0 | 0 | 0 | 0 | 1 | 1 |
| 22 | 1 | 0 | 0 | 0 | 1 | 0 | 0 | 1 | 1 | 0 | 1 |
| 23 | 1 | 1 | 1 | 0 | 1 | 0 | 0 | 0 | 1 | 1 | 1 |
| 24 | 1 | 1 | 1 | 1 | 1 | 0 | 1 | 1 | 1 | 1 | 0 |
| 25 | 1 | 1 | 0 | 0 | 0 | 1 | 1 | 1 | 0 | 0 | 1 |
| 26 | 1 | 0 | 1 | 1 | 0 | 1 | 0 | 0 | 1 | 1 | 0 |
| 27 | 1 | 1 | 1 | 1 | 0 | 1 | 0 | 1 | 1 | 1 | 0 |
| 28 | 1 | 0 | 1 | 0 | 1 | 1 | 1 | 0 | 1 | 0 | 0 |
| 29 | 1 | 0 | 1 | 1 | 1 | 1 | 1 | 1 | 1 | 0 | 0 |
| 30 | 1 | 1 | 1 | 1 | 1 | 1 | 1 | 1 | 1 | 1 | 1 |
| 31 | 1 | 0 | 0 | 0 | 0 | 0 | 0 | 0 | 0 | 0 | 0 |

**12.** The method according to claim 10 or 11, wherein the first interleaving pattern is shown in Table #21 or Table #22 below:

Table #21

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 30 | 4 | 17 | 8 | 28 | 12 | 5 | 16 | 26 | 20 | 24 | 24 | 31 | 28 | 6 |
| 1 | 13 | 5 | 15 | 9 | 18 | 13 | 23 | 17 | 2 | 21 | 16 | 25 | 9 | 29 | 14 |
| 2 | 22 | 6 | 4 | 10 | 19 | 14 | 10 | 18 | 29 | 22 | 7 | 26 | 11 | 30 | 27 |
| 3 | 3 | 7 | 1 | 11 | 12 | 15 | 25 | 19 | 21 | 23 | 20 | 27 | 0 | 31 | 8 |

Table #22

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 16 | 4 | 4 | 8 | 15 | 12 | 10 | 16 | 12 | 20 | 20 | 24 | 24 | 28 | 28 |
| 1 | 14 | 5 | 7 | 9 | 1 | 13 | 17 | 17 | 11 | 21 | 21 | 25 | 25 | 29 | 29 |
| 2 | 3 | 6 | 9 | 10 | 8 | 14 | 5 | 18 | 2 | 22 | 22 | 26 | 26 | 30 | 30 |
| 3 | 0 | 7 | 6 | 11 | 13 | 15 | 19 | 19 | 18 | 23 | 23 | 27 | 27 | 31 | 31 |

wherein i represents an (i+1)th row in the first encoding sequence, P(i) represents a row element that corresponds to a (P(i)+1)th row in the first encoding sequence and that is placed in an (i+1)th row in the second encoding sequence, and 0≤i≤31.

13. The method according to claim 10 or 11, wherein a length of the to-be-encoded sequence is K, 3≤K≤11, and

when K is equal to 3, the first interleaving pattern is shown in Table #23:

Table #23

| i | P(i) | i | P(i) | i | P(i) | i | P(i) | i | P(i) | i | P(i) | i | P(i) | i | P(i) |
|---|------|---|------|---|------|----|------|----|------|----|------|----|------|----|------|
| 0 | 28 | 4 | 22 | 8 | 2 | 12 | 1 | 16 | 4 | 20 | 27 | 24 | 18 | 28 | 10 |
| 1 | 14 | 5 | 16 | 9 | 29 | 13 | 31 | 17 | 13 | 21 | 17 | 25 | 9 | 29 | 11 |
| 2 | 25 | 6 | 8 | 10 | 30 | 14 | 15 | 18 | 3 | 22 | 6 | 26 | 24 | 30 | 5 |
| 3 | 23 | 7 | 26 | 11 | 21 | 15 | 20 | 19 | 12 | 23 | 19 | 27 | 0 | 31 | 7 |

or when K is equal to 4, the first interleaving pattern is shown in Table #24:

Table #24

| i | P(i) | i | P(i) | i | P(i) | i | P(i) | i | P(i) | i | P(i) | i | P(i) | i | P(i) |
|---|------|---|------|---|------|----|------|----|------|----|------|----|------|----|------|
| 0 | 30 | 4 | 20 | 8 | 6 | 12 | 12 | 16 | 13 | 20 | 9 | 24 | 28 | 28 | 7 |
| 1 | 29 | 5 | 14 | 9 | 3 | 13 | 25 | 17 | 0 | 21 | 4 | 25 | 27 | 29 | 5 |
| 2 | 21 | 6 | 15 | 10 | 24 | 14 | 23 | 18 | 11 | 22 | 31 | 26 | 26 | 30 | 18 |
| 3 | 1 | 7 | 17 | 11 | 19 | 15 | 8 | 19 | 22 | 23 | 2 | 27 | 16 | 31 | 10 |

or when K is equal to 5, the first interleaving pattern is shown in Table #25:

Table #25

| i | P(i) | i | P(i) | i | P(i) | i | P(i) | i | P(i) | i | P(i) | i | P(i) | i | P(i) |
|---|------|---|------|---|------|----|------|----|------|----|------|----|------|----|------|
| 0 | 30 | 4 | 4 | 8 | 3 | 12 | 16 | 16 | 25 | 20 | 24 | 24 | 21 | 28 | 15 |
| 1 | 17 | 5 | 0 | 9 | 13 | 13 | 10 | 17 | 6 | 21 | 27 | 25 | 19 | 29 | 7 |
| 2 | 14 | 6 | 5 | 10 | 11 | 14 | 29 | 18 | 23 | 22 | 9 | 26 | 26 | 30 | 12 |
| 3 | 8 | 7 | 28 | 11 | 2 | 15 | 31 | 19 | 1 | 23 | 18 | 27 | 22 | 31 | 20 |

or when K is equal to 6, the first interleaving pattern is shown in Table #26:

Table #26

| i | P(i) | i | P(i) | i | P(i) | i | P(i) | i | P(i) | i | P(i) | i | P(i) | i | P(i) |
|---|------|---|------|---|------|----|------|----|------|----|------|----|------|----|------|
| 0 | 29 | 4 | 7 | 8 | 25 | 12 | 5 | 16 | 3 | 20 | 20 | 24 | 22 | 28 | 10 |
| 1 | 16 | 5 | 21 | 9 | 4 | 13 | 6 | 17 | 15 | 21 | 8 | 25 | 13 | 29 | 19 |
| 2 | 26 | 6 | 1 | 10 | 28 | 14 | 9 | 18 | 14 | 22 | 2 | 26 | 31 | 30 | 27 |
| 3 | 24 | 7 | 0 | 11 | 30 | 15 | 17 | 19 | 12 | 23 | 23 | 27 | 18 | 31 | 11 |

or when K is equal to 7, the first interleaving pattern is shown in Table #27:

Table #27

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 17 | 4 | 22 | 8 | 1 | 12 | 7 | 16 | 19 | 20 | 29 | 24 | 20 | 28 | 28 |
| 1 | 26 | 5 | 3 | 9 | 8 | 13 | 12 | 17 | 31 | 21 | 6 | 25 | 16 | 29 | 11 |
| 2 | 24 | 6 | 21 | 10 | 10 | 14 | 23 | 18 | 14 | 22 | 25 | 26 | 13 | 30 | 5 |
| 3 | 9 | 7 | 0 | 11 | 18 | 15 | 2 | 19 | 15 | 23 | 27 | 27 | 30 | 31 | 4 |

or when K is equal to 8, the first interleaving pattern is shown in Table #28:

Table #28

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 15 | 8 | 31 | 12 | 27 | 16 | 1 | 20 | 29 | 24 | 12 | 28 | 9 |
| 1 | 17 | 5 | 10 | 9 | 18 | 13 | 7 | 17 | 20 | 21 | 4 | 25 | 13 | 29 | 5 |
| 2 | 16 | 6 | 8 | 10 | 6 | 14 | 26 | 18 | 3 | 22 | 0 | 26 | 14 | 30 | 19 |
| 3 | 28 | 7 | 2 | 11 | 11 | 15 | 22 | 19 | 23 | 23 | 21 | 25 | 27 | 31 | 24 |

or when K is equal to 9, the first interleaving pattern is shown in Table #29:

Table #29

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 7 | 8 | 1 | 12 | 3 | 16 | 27 | 20 | 20 | 24 | 18 | 28 | 9 |
| 1 | 16 | 5 | 23 | 9 | 0 | 13 | 8 | 17 | 28 | 21 | 4 | 25 | 22 | 29 | 24 |
| 2 | 12 | 6 | 6 | 10 | 31 | 14 | 29 | 18 | 15 | 22 | 19 | 26 | 14 | 30 | 13 |
| 3 | 10 | 7 | 21 | 11 | 26 | 15 | 17 | 19 | 5 | 23 | 11 | 27 | 2 | 31 | 25 |

or when K is equal to 10, the first interleaving pattern is shown in Table #30:

Table #30

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 16 | 4 | 25 | 8 | 3 | 12 | 23 | 16 | 7 | 20 | 21 | 24 | 29 | 28 | 28 |
| 1 | 15 | 5 | 24 | 9 | 1 | 13 | 0 | 17 | 19 | 21 | 6 | 25 | 14 | 29 | 9 |
| 2 | 11 | 6 | 8 | 10 | 20 | 14 | 13 | 18 | 2 | 22 | 30 | 26 | 27 | 30 | 18 |
| 3 | 10 | 7 | 4 | 11 | 26 | 15 | 5 | 19 | 12 | 23 | 31 | 27 | 22 | 31 | 17 |

or when K is equal to 11, the first interleaving pattern is shown in Table #31:

Table #31

| i | P(i) | i | P(i) | i | P(i) | i | P(i) | i | P(i) | i | P(i) | i | P(i) | i | P(i) |
|---|------|---|------|---|------|---|------|---|------|---|------|---|------|---|------|
| 0 | 30 | 4 | 27 | 8 | 4 | 12 | 7 | 16 | 10 | 20 | 24 | 24 | 23 | 28 | 5 |
| 1 | 29 | 5 | 19 | 9 | 21 | 13 | 12 | 17 | 16 | 21 | 31 | 25 | 9 | 29 | 17 |
| 2 | 18 | 6 | 6 | 10 | 20 | 14 | 25 | 18 | 14 | 22 | 8 | 26 | 3 | 30 | 11 |
| 3 | 15 | 7 | 22 | 11 | 0 | 15 | 13 | 19 | 28 | 23 | 1 | 27 | 2 | 31 | 26 |

wherein i represents an (i+1)$^{th}$ row in the first encoding sequence code, P(i) represents a row element that is in a (P(i)+1)$^{th}$ row in the first encoding sequence and that is placed in an (i+1)$^{th}$ row in the second encoding sequence, and $0 \leq i \leq 31$.

14. A communication apparatus, comprising a module or a unit configured to perform the method according to any one of claims 1 to 8, or a module or a unit configured to perform the method according to any one of claims 9 to 13.

15. A communication apparatus, comprising at least one processor, wherein the at least one processor is coupled to at least one memory, and the at least one processor is configured to execute a computer program or instructions stored in the at least one memory, to cause the communication apparatus to perform the method according to any one of claims 1 to 8 or the method according to any one of claims 9 to 13.

16. A chip, comprising a processor and a communication interface, wherein the communication interface is configured to: receive a to-be-encoded sequence, and send the to-be-encoded sequence to the processor; the processor encodes and interleaves the to-be-encoded sequence according to the method according to any one of claims 1 to 8, to obtain a third codeword sequence; and the communication interface is further configured to output the third codeword sequence; or
the communication interface is configured to: receive a to-be-encoded sequence, and send the to-be-encoded sequence to the processor; the processor encodes, based on a second encoding sequence, the to-be-encoded sequence according to the method according to any one of claims 9 to 13, to obtain a third codeword sequence; and the communication interface is configured to output the third codeword sequence.

17. A computer-readable storage medium, wherein the computer-readable storage medium stores computer instructions, and when the computer instructions are run on a computer, the method according to any one of claims 1 to 8 or the method according to any one of claims 9 to 13 is implemented.

18. A computer program product, wherein the computer program product comprises computer program code, and when the computer program code is run on a computer, the method according to any one of claims 1 to 8 or the method according to any one of claims 9 to 13 is implemented.

Network
device

FIG. 1

200

| | |
|---|---|
| Encode a to-be-encoded sequence based on a first encoding sequence, to obtain a first codeword sequence whose length is 32 bits, where the first encoding sequence is a basis sequence corresponding to small packet encoding | S210 |
| Interleave the first codeword sequence to obtain a second codeword sequence | S220 |
| Puncture the second codeword sequence based on a value E, to obtain a third codeword sequence | S230 |
| Output the third codeword sequence | S240 |

FIG. 2

Step 1: Randomly generate a first random sequence whose length is K1 and a second random sequence whose length is K2

Step 2: Separately encode the first random sequence and the second random sequence, to obtain a first random codeword sequence whose length is 32 and a second random codeword sequence whose length is 32

Step 3: Determine a value of first performance of a sequence obtained by puncturing an $i^{th}$ position of the first random codeword sequence and a value of first performance of a sequence obtained by puncturing an $i^{th}$ position of the second random codeword sequence, where $1 \leq i \leq 32$

Step 4: Determine an average value $A_i$ of a first value and a second value

Step 5: Determine a first position, where the first position is a position corresponding to a smallest value in $A_1$ to $A_{32}$, and the first position is a $1^{st}$ puncturing position

Step 6:
Determine that a current quantity of puncturing positions is 1, and determine whether 1 is less than (32–E)

No

Output a first interleaving pattern

Yes

Step 7: Randomly generate a third random sequence whose length is K1 and a fourth random sequence whose length is K2

Step 8: Separately encode the third random sequence and the fourth random sequence, to obtain a third random codeword sequence whose length is 32 and a fourth random codeword sequence whose length is 32

Step 9: Determine a fifth random codeword sequence and a sixth random codeword sequence, where the fifth random codeword sequence is a sequence obtained by puncturing a bit in a first position of the third random codeword sequence, and the sixth random codeword sequence is a sequence obtained by puncturing a bit in a first position of the fourth random codeword sequence

Step 10: Determine a value of first performance of a sequence obtained by puncturing a $j^{th}$ position of the fifth random codeword sequence and a value of first performance of a sequence obtained by puncturing a $j^{th}$ position of the sixth random codeword sequence, where $1 \leq j \leq 31$

Step 11: Determine an average value $A_j$ of a third value and a fourth value

Step 12: Determine a second position, where the second position is a position corresponding to a smallest value in $A_1$ to $A_{31}$ determined in step 11, and the second position is a $2^{nd}$ puncturing position

Step 13:
Determine that a current quantity of puncturing positions is 2, and determine whether 2 is less than (32–E)

No

Output a first interleaving pattern

Yes

...

FIG. 3

400

| Perform row interleaving on a first encoding matrix, to obtain a second encoding matrix, where a first encoding sequence is a basis sequence corresponding to small packet encoding | S410 |

| Encode a to-be-encoded sequence based on the second encoding matrix, to obtain a second codeword sequence whose length is 32 | S420 |

| Puncture the second codeword sequence based on a value E, to obtain a third codeword sequence | S430 |

| Output the third codeword sequence | S440 |

FIG. 4

K=11

FIG. 5

Communication apparatus 600

Processing unit 610

Communication unit 620

FIG. 6

Communication apparatus 700

Processor
710

Memory
720

Communication
interface 730

FIG. 7

## INTERNATIONAL SEARCH REPORT

| International application No. |
|---|
| **PCT/CN2023/109911** |

**A.    CLASSIFICATION OF SUBJECT MATTER**

H04L 1/00(2006.01)i

According to International Patent Classification (IPC) or to both national classification and IPC

**B.    FIELDS SEARCHED**

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

CNABS; CNTXT; CNKI; VEN; USTXT; WOTXT; EPTXT; 3GPP; IEEE: 里德穆勒, 编码, 小包, 交织, 打孔, 速率, 匹配, RM, coding, small block, interleaving, puncturing, rate, match

**C.    DOCUMENTS CONSIDERED TO BE RELEVANT**

| Category* | Citation of document, with indication, where appropriate, of the relevant passages | Relevant to claim No. |
|---|---|---|
| X | SEQUANS COMMUNICATIONS. "Discussion of LTE-RM decoding ambiguity" *3GPP TSG-RAN WG1 NR #2, R1-1709903*, 16 June 2017 (2017-06-16), pages 1-3 | 1-18 |
| X | SEQUANS COMMUNICATIONS. "Essential enhancement to rate matching of Reed Muller code" *3GPP TSG-RAN WG1 Meeting AH_NR#3, R1-1715457*, 10 September 2017 (2017-09-10), pages 1-2 and 8-9 | 1-18 |
| A | CN 115085739 A (HUAWEI TECHNOLOGIES CO., LTD.) 20 September 2022 (2022-09-20) entire document | 1-18 |
| A | EP 0913825 A2 (HEWLETT-PACKARD CO.) 06 May 1999 (1999-05-06) entire document | 1-18 |

☐ Further documents are listed in the continuation of Box C.         ☑ See patent family annex.

| * | Special categories of cited documents: | | |
|---|---|---|---|
| "A" | document defining the general state of the art which is not considered to be of particular relevance | "T" | later document published after the international filing date or priority date and not in conflict with the application but cited to understand the principle or theory underlying the invention |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **21 March 2024** | **23 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/109911**

| Patent document cited in search report | | | Publication date (day/month/year) | Patent family member(s) | | | Publication date (day/month/year) |
|---|---|---|---|---|---|---|---|
| CN | 115085739 | A | 20 September 2022 | WO | 2022188752 | A1 | 15 September 2022 |
| EP | 0913825 | A2 | 06 May 1999 | EP | 0913825 | A3 | 09 September 2009 |
| | | | | EP | 0913825 | B1 | 01 May 2013 |

Form PCT/ISA/210 (patent family annex) (July 2022)